(19) Europäisches Patentamt
European Patent Office
Office européen des brevets

(11) EP 0 698 812 A2

(12) **EUROPEAN PATENT APPLICATION**

(43) Date of publication:
**28.02.1996 Bulletin 1996/09**

(51) Int Cl.[6]: **G03B 27/53**

(21) Application number: **95401927.9**

(22) Date of filing: **22.08.1995**

(84) Designated Contracting States:
**DE FR GB**

(30) Priority: **22.08.1994 JP 219463/94**

(71) Applicant: **SONY CORPORATION**
**Tokyo (JP)**

(72) Inventor: **Kasuga, Takashi,**
**c/o Sony Corporation**
**Shinagawa-ku, Tokyo (JP)**

(74) Representative: **Thévenet, Jean-Bruno et al**
**F-75340 Paris Cédex 07 (FR)**

(54) **Method for alignment of manufacturing semiconductor apparatus**

(57) Alignment correction coefficients are calculated by a method of least squares with reference to the coordinates of each of the alignment marks and the coordinates of the rational grid points. Corrected coordinates of the alignment marks are derived from the coordinates of the rational grid points on the basis of the alignment mark correction coefficients, each of their statistical functions are calculated, and the differences of these coordinates are calculated. The residuals at each of the alignment marks are calculated with reference to the difference between the alignment displacement tolerance values in the predetermined X and Y directions and their coordinates. The corrected coordinates of the alignment marks associated with the first pattern for optically exposing the second pattern from the alignment mark correction coefficients and their random number elements when the residual sum of squares becomes a minimum value. In this way, optimal correction of the alignment can be carried out even in the case that the random elements in the alignment mark displacement components from the rational grid point do not follow a normal distribution.

F I G. 5

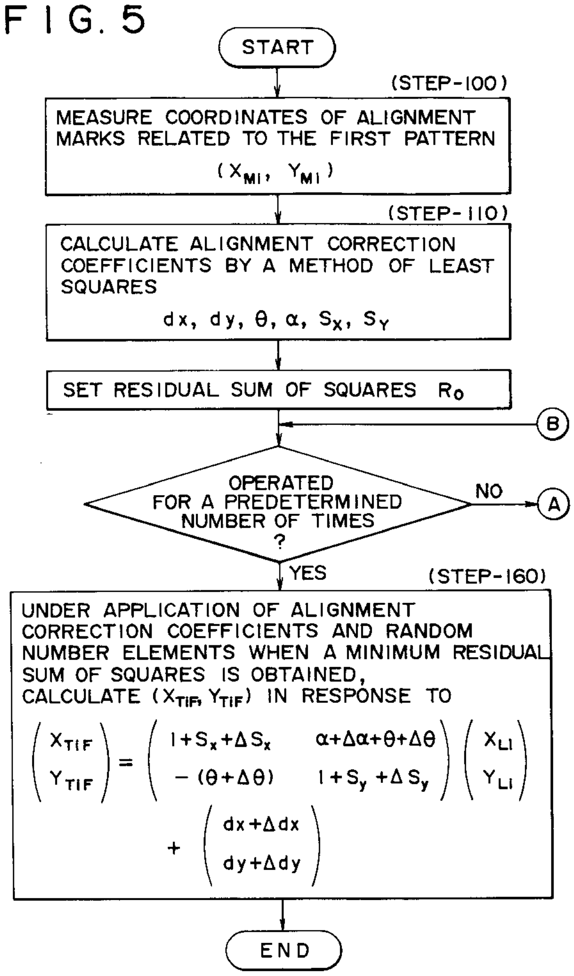


EP 0 698 812 A2

## Description

BACKGROUND OF THE INVENTION

Field of the Invention

This invention relates to an alignment method in an optical exposing process for a semiconductor device, and more particularly a new advanced global alignment method.

Description of Related Art

As the trend towards high integration in VLSI and large-sized chips has developed in recent years, requirement for a position alignment accuracy in a stepping device has become severe year after year. For instance, in LSIs such as 64M DRAMs or 16M SRAMs being developed at present with a 0.35 μm class of design rule, assuming that the mean value of positional displacement in alignment is defined as $X_{ave}$ and the standard deviation is defined as σ, then a high accuracy in position alignment having 0.1 μm or less as a target value of $|X_{ave}| + 3\sigma$ is required for the entire surface of the wafer. In this case, an appendix letter of "ave" means a mean value.

The optical exposure operation for the LSI chip in the related art stepping device is carried out by tracking a grid pattern under a stepping operation of a wafer stage. Thereafter, in order to form a second pattern on a first pattern already formed on the wafer, a resist is formed on the first pattern and exposed through reticle having the second pattern formed thereon. During this optical exposure operation, the positions of the wafer alignment marks (hereinafter merely called as alignment marks) associated with the first pattern for each of the optical exposure shots already formed on the wafer are measured by an alignment sensing system. Accordingly, an improvement in the high precision alignment capability is required at the level of the stepping device. In turn, it is also necessary to improve alignment operation such as a statistical correction against the alignment in order to achieve the best alignment at each optical exposure shot.

One kind of alignment correction used in the related art stepping device is the advanced global alignment process (sometimes hereinafter simply called an alignment method). According to this alignment process, a wafer stage of the stepping device is moved to an exposure position in response to a statistical estimation calculation by reference to positional information from a plurality of alignment marks. A summary of a principle of this advanced global alignment method will now be described.

It shall be supposed that a second pattern is formed on the first pattern that is already formed. Prior to the formation of the second pattern, the positions of the alignment marks associated with the first pattern for each of the optical exposure shots already formed on the wafer are measured by the alignment sensing system by reference to the wafer stage. Then, as shown in Fig. 1 and described in detail as follows, an optical exposure shot layout is converted in such a manner that the positional displacement between the positions of the rational grid points (hereinafter sometimes called rational grid points) corresponding to each of the alignment marks and the measured position of each of the alignment marks may become minimum. Thereafter the alignment operation is performed to make an optical exposure of the resist. In Fig. 1, rational grid points are connected by solid lines, measured positions of each of the alignment marks are connected by dotted lines and the points after conversion of the optical exposure shot layouts (rational grid points) are connected by alternate long and short dash lines.

At present, one particular rational grid point will be studied. The measured coordinates of the alignment mark corresponding to this rational grid point is defined as $a_M$ $(X_M, Y_M)$ (refer to Fig. 2). In turn, the coordinates of the rational grid point on the wafer corresponding to this alignment mark are defined as $a_L$ $(X_L, Y_L)$. In the specification, the appendix letter "v" added to a symbol or the like designates a vector. In the case that the wafer is processed with a heat treatment or passed through various film forming steps or the like, the coordinates $a_L$ $(X_L, Y_L)$ do not usually coincide with the coordinates $a_M$ $(X_M, Y_M)$. If the measurement accuracy of the alignment marks can be ignored, the vector $(a_{MV} - a_{LV})$ which is a difference between a vector $a_{MV}$ and a vector $a_{LV}$, is the vector indicating a positional displacement from the rational grid points caused by a deformation of the wafer made by the manufacturing process of a semiconductor device or a positional displacement at the wafer stage during loading of the wafer (positional displacement after pre-alignment of the wafer).

Accordingly, when the alignment is carried out, a conversion operation with a certain kind of conversion operand A is performed against a certain point $a_L$ on the rational grid point and then a residual vector $e_V$ between the vector $a_{TV} = Aa_{Lv}$ and the vector $a_{Mv}$ of the obtained point is calculated. The above operation is carried out for a plurality of alignment marks (the number N). It is satisfactory that the conversion operand A is determined in such a way that a sum of the residual vector $e_v$ at each of the alignment marks may become minimum. Then, it is satisfactory that the coordinates $a_L$ of the rational grid point is converted into a coordinates $a_T$ in response to the conversion operand A, an alignment operation is carried out in response to the converted coordinates $a_T$ and an optical exposure shot is carried out to optically expose the resist.

In practice, the wafer stage system is operated such that the alignment displacement between the first pattern and the second pattern becomes minimum in response to a positional displacement from the rational grid point of the measured alignment marks and the optical exposure shot layout for use in forming the second pattern is exposed while being displaced from the rational grid point.

Although the nature of wafer deformation caused by a manufacturing process for the actual semiconductor device is complex, the following may be considered as the major causes :

(A) Offsets (shifts) dx and dy, which are errors of the alignment marks in the X and Y directions, respectively.

(B) A rotation θ, which is the error of the alignment mark in its rotating direction.

(C) An orthogonal degree of layout α, which is the error in the orthogonal degree in the layout of each of the alignment marks, and

(D) Scalings $S_X$, $S_Y$ which are variations in the multiplication factor of each of the alignment marks in the X and Y directions, respectively.

These technical concepts are illustrated in Figs. 3A, 3B, 4A and 4B. Both (A) offsets (refer to Fig. 3A) and (B) rotation (refer to Fig. 3B) are caused by a loading of the wafer into the wafer stage. (C) orthogonal degree of layout (refer to Fig. 4A) is caused by an inaccuracy in the wafer stage when the first pattern is optically exposed. (D) scaling (refer to Fig. 4B) is caused by a manufacturing process element of a semiconductor device such as a film formation stage and the like. These causes (A) to (D) are not necessarily separated in a clear manner. In Figs. 3A, 3B, 4A and 4B, the rational grid points are connected by solid lines and the alignment marks on the deformed wafer are connected by dotted lines.

The related art stepping device performs a correction of alignment with these four causes being applied as major causes of variation. That is, the variation operand A is determined with the method of least squares in such a way that a sum of squares of residual of displacement between the coordinates of the alignment marks measured and the coordinates after the coordinates of the rational grid points corresponding to such alignment marks become a minimum in response to these causes. Then, an optical exposure shot layout for use in forming the second pattern is determined in response to the positional coordinates of the alignment marks (positional coordinates after correction of the alignment marks) obtained through a converting operation based on the conversion operand A.

The conversion operation related to each of the causes is expressed with a 2 x 2 matrix and the conversion operation of

$$\begin{pmatrix} X_{Ti} \\ Y_{Ti} \end{pmatrix} = \begin{pmatrix} X_{Li} + dx \\ Y_{Li} + dy \end{pmatrix}$$

Equation (7)

is carried out for (A) offset, where dx and dy are errors (offsets) of the alignment marks in the X and Y directions, respectively. $X_{Ti}$ and $Y_{Ti}$ in the equation above represent the X coordinate and Y coordinate of the alignment mark $a_{Ti}$ of the i-th order [i = 0 to (N - 1)] after conversion. $X_{Li}$ and $Y_{Li}$ represent the X coordinate and Y coordinate of the rational grid point $a_{Li}$ of the i-th order [i = 0 to (N - 1)]. A similar relation is applied to the following equation.
As for the (B) rotation, the converting operation based on

$$\begin{pmatrix} X_{Ti} \\ Y_{Ti} \end{pmatrix} = \begin{pmatrix} \cos\theta & \sin\theta \\ -\sin\theta & \cos\theta \end{pmatrix} \begin{pmatrix} X_{Li} \\ Y_{Li} \end{pmatrix} \cong \begin{pmatrix} 1 & \theta \\ -\theta & 1 \end{pmatrix} \begin{pmatrix} X_{Li} \\ Y_{Li} \end{pmatrix}$$

Equation (8)

is carried out, where θ is an angle of rotation (unit : radian) and a value of θ during an actual alignment mark operation is in an order of $10^{-6}$ radian. Accordingly, there is no problem when sinθ = θ and cosθ = 1 are set to be approximate to each other and the above equation can be attained.

In addition, as for (C) orthogonal degree of layout, the converting operation is carried out with the following equation:

$$\begin{pmatrix} X_{Ti} \\ Y_{Ti} \end{pmatrix} = \begin{pmatrix} 1 & \tan\alpha \\ 0 & 1 \end{pmatrix} \begin{pmatrix} X_{Li} \\ Y_{Li} \end{pmatrix}$$

$$\simeq \begin{pmatrix} 1 & \alpha \\ 0 & 1 \end{pmatrix} \begin{pmatrix} X_{Li} \\ Y_{Li} \end{pmatrix}$$

Equation (9)

where $\alpha$ expresses an orthogonal degree of layout (unit: radian) and a value of this $\alpha$ is $10^{-6}$ radian during an actual alignment mark operation. Accordingly, there is no problem if $\tan\alpha = \alpha$ is approximated, resulting in that the above equation may be obtained.

In turn, as for (D) scaling, the following conversion of

$$\begin{pmatrix} X_{Ti} \\ Y_{Ti} \end{pmatrix} = \begin{pmatrix} 1+S_x & 0 \\ 0 & 1+S_y \end{pmatrix} \begin{pmatrix} X_{Li} \\ Y_{Li} \end{pmatrix}$$

Equation (10)

is carried out, where $S_X$, $S_Y$ are values of scaling in the X and Y directions, respectively, and an order to become problem is a level of about 1 ppm.

In addition, assuming a complex operation of three converting operations according to the equations (8), (9) and (10), the corresponding operation is as follows :

$$\begin{pmatrix} X_{Ti} \\ Y_{Ti} \end{pmatrix} \doteq \begin{pmatrix} 1 & \theta \\ -\theta & 1 \end{pmatrix} \begin{pmatrix} 1 & \alpha \\ 0 & 1 \end{pmatrix} \begin{pmatrix} 1+S_x & 0 \\ 0 & 1+S_y \end{pmatrix} \begin{pmatrix} X_{Li} \\ Y_{Li} \end{pmatrix}$$

Equation (11)

Since it may be assumed that $(\alpha + \theta)S_Y = 0$, $\theta \cdot S_X = 0$ and $\alpha \cdot \theta = 0$ can be attained, the equation (11) is changed and the following equation is obtained:

$$\begin{pmatrix} X_{Ti} \\ Y_{Ti} \end{pmatrix} = \begin{pmatrix} 1+S_x & \alpha+\theta \\ -\theta & 1+S_y \end{pmatrix} \begin{pmatrix} X_{Li} \\ Y_{Li} \end{pmatrix}$$

Equation (12)

Under such approximate conditions as above, these three converting operations can be carried out. In addition, the coordinates $a_{Ti}$ ($X_{Ti}$, $Y_{Ti}$) after correction of alignment (after converting operation) can be simply expressed under an assumption of positional displacements dx and dy caused by offsets as follows :

$$X_{Ti} = (1 + S_X)\, X_{Li} + (\alpha + \theta)\, Y_{Li} + dx \qquad \text{Equation (13-1)}$$

$$Y_{Ti} = -\theta_{Li} + (1 + S_Y)\, Y_{Li} + dy \qquad \text{Equation (13-2)}$$

In this case, if it is assumed that :
$a = 1 + S_X$
$b = \alpha + \theta$
$c = dx$
$d = -\theta$
$e = 1 + S_Y$
$f = dy$
the equations (13-1) and (13-2) can be expressed as the following equations (14-1) and (14-2).

$$X_{Ti} = aX_{Li} + bY_{Li} + c \qquad \text{Equation (14-1)}$$

$$Y_{Ti} = dX_{Li} + eY_{Li} + f \qquad \text{Equation (14-2)}$$

Accordingly, if the measured coordinates of the i-th order of alignment mark are defined as $a_{Mi}$ ($X_{Mi}$, $Y_{Mi}$), the residual values $E_{Xi}$ and $E_{Yi}$ can be expressed as follows :

$$\begin{aligned} E_{Xi} &= X_{Mi} - X_{Ti} \\ &= X_{Mi} - (aX_{Li} + bY_{Li} + c) \end{aligned} \qquad \text{Equation (15-1)}$$

$$\begin{aligned} E_{Yi} &= Y_{Mi} - Y_{Ti} \\ &= Y_{Mi} - (dX_{Li} + eY_{Li} + f) \end{aligned} \qquad \text{Equation (15-2)}$$

Then, the coefficients a, b, c, d, e and f are determined in such a way that the sum of the squares of each of the residual coordinate values $E_{Xi}$ and $E_{Yi}$ of the alignment marks of the number of N ranging from 0-th alignment mark to the (N - 1)-th alignment mark, i.e.

$$\Sigma^{\bullet} E_{Xi}^{2} = \Sigma^{\bullet}[X_{Mi} - (aX_{Li} + bY_{Li} + c)]^{2}$$

$$\Sigma^{\bullet} E_{Yi}^{2} = \Sigma^{\bullet}[Y_{Mi} - (dX_{Li} + eY_{Li} + f)]^{2}$$

may become minimum.

Such a method as described above is the related art alignment method. That is, it is generally known that a proper amount of correction against each of the causes can be determined unconditionally through a method of least squares. In the present specification, the item "Σ" is meant by a sum of a physical amount (expressed by the equation subsequent to Σ) concerning the alignment marks of the number of N ranging from 0-th alignment mark to (N-1)-th alignment mark unless otherwise specified. Each of the coefficients is partially differentiated and put in order as follows:

$$\frac{\partial}{\partial a}\left(\sum_{i=0}^{N-1} E_{Xi}^{2}\right) = \frac{\partial}{\partial b}\left(\sum_{i=0}^{N-1} E_{Xi}^{2}\right) = \frac{\partial}{\partial c}\left(\sum_{i=0}^{N-1} E_{Xi}^{2}\right) = 0 \qquad \text{Equation (16-1)}$$

$$\frac{\partial}{\partial d}\left(\sum_{i=0}^{N-1} E_{Yi}^{2}\right) = \frac{\partial}{\partial e}\left(\sum_{i=0}^{N-1} E_{Yi}^{2}\right) = \frac{\partial}{\partial f}\left(\sum_{i=0}^{N-1} E_{Yi}^{2}\right) = 0 \qquad \text{Equation (16-2)}$$

Accordingly, in reference to the equations (16-1) and (16-2), the following relationships may be obtained:

$$\begin{pmatrix} \sum_{i=0}^{N-1} X_{Li}^{2} & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^{2} & \sum_{i=0}^{N-1} Y_{Li} \\ \sum_{i=0}^{N-1} X_{Li} & \sum_{i=0}^{N-1} Y_{Li} & \sum_{i=0}^{N-1} i \end{pmatrix} \begin{pmatrix} a \\ b \\ c \end{pmatrix} = \begin{pmatrix} \sum_{i=0}^{N-1} X_{Mi}X_{Li} \\ \sum_{i=0}^{N-1} X_{Mi}Y_{Li} \\ \sum_{i=0}^{N-1} X_{Mi} \end{pmatrix}$$

$$\begin{pmatrix} \sum_{i=0}^{N-1} X_{Li}^{2} & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^{2} & \sum_{i=0}^{N-1} Y_{Li} \\ \sum_{i=0}^{N-1} X_{Li} & \sum_{i=0}^{N-1} Y_{Li} & \sum_{i=0}^{N-1} i \end{pmatrix} \begin{pmatrix} d \\ e \\ f \end{pmatrix} = \begin{pmatrix} \sum_{i=0}^{N-1} Y_{Mi}X_{Li} \\ \sum_{i=0}^{N-1} Y_{Mi}Y_{Li} \\ \sum_{i=0}^{N-1} Y_{Mi} \end{pmatrix}$$

$$a = 1 + S_X$$

$$b = \alpha + \theta$$

$$c = dx$$

$$d = -\theta$$

$$e = 1 + S_Y$$

$$f = dy$$

If B is defined as

$$\begin{pmatrix} \sum_{i=0}^{N-1} X_{Li}^{2} & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^{2} & \sum_{i=0}^{N-1} Y_{Li} \\ \sum_{i=0}^{N-1} X_{Li} & \sum_{i=0}^{N-1} Y_{Li} & \sum_{i=0}^{N-1} i \end{pmatrix} = B$$

Equation (17)

then each of the above two equations becomes

$$\begin{pmatrix} a \\ b \\ c \end{pmatrix} B^{-1} = \begin{pmatrix} \sum_{i=0}^{N-1} X_{Mi} X_{Li} \\ \sum_{i=0}^{N-1} X_{Mi} Y_{Li} \\ \sum_{i=0}^{N-1} X_{Mi} \end{pmatrix}$$

Equation (18)

$$\begin{pmatrix} d \\ e \\ f \end{pmatrix} B^{-1} = \begin{pmatrix} \sum_{i=0}^{N-1} Y_{Mi} X_{Li} \\ \sum_{i=0}^{N-1} Y_{Mi} Y_{Li} \\ \sum_{i=0}^{N-1} Y_{Mi} \end{pmatrix}$$

Equation (19)

In this way, it is possible to calculate the six coefficients a, b, c, d, e and f. That is, it is possible to determine unconditionally the alignment coefficients dx, dy, $\theta$, $\alpha$, $S_X$, $S_Y$. In other words, it is possible to analyze the causes of the alignment displacement.

It is well known in the related art alignment method that the most preferable correction of the alignment can be performed more easily and analytically in view of a technical concept of making sum of least squares of the residual values $E_{Xi}$ and $E_{Yi}$ by applying the method of least squares. In other words, it is known that the most preferable amount of correction in the alignment for making a sum of squares of residuals $E_{Xi}$, $E_{Yi}$ minimum can be analytically calculated only by deriving an inverse matrix of the matrix B. Finally the residuals may result in only random components or high degree component of scaling which can not be corrected in view of principle.

Such a related art alignment method as described above is effective whenever the random components - which cannot be corrected by a hardware normally installed on the stepping device in view of its principle - are relatively near a normal distribution. However, in view of the actual structure of the semiconductor device, a minimum setting of the sum of squares of residuals is not always a necessary condition and may not necessarily make the most preferable amount of alignment of correction.

The alignment operation in the practical semiconductor device is defined as an operation in which two patterns are set so as to overlap each other, both patterns being designed with reference to an alignment displacement tolerance value set in response to an attainable alignment accuracy. Normally, the first preformed pattern shown in Fig. 15A (for example, an electrical wiring pattern) is designed to be larger than the second pattern (for example, a contact hole pattern) with reference to a displacement in alignment as shown in Fig. 15B. In this figure, the lengths $tol_X$ and $tol_Y$ designate alignment displacement tolerance values in the X and Y directions, and the alignment displacement values in the X and Y directions are designated by $\Delta X$ and $\Delta Y$, respectively. Accordingly, it may easily be understood that a necessary and sufficient condition for establishing alignment in manufacturing the semiconductor device arises from the fact that :

$$\Delta X < tol_X \qquad \text{Equation (20-1)}$$

$$\Delta Y < tol_Y \qquad \text{Equation (20-2)}$$

are fulfilled for all patterns. In other words, it is satisfactory that all the second patterns to be formed satisfy the equations (20-1) and (20-2), respectively. In turn, in the case where if a part of the second pattern is exposed outside the first pattern, i.e. if just a part of the second pattern to be formed does not satisfy the equation (20-1) or (20-2), it becomes impossible to form a normal electrical contact, for example. In other words, it is necessary that an absolute value of difference between a positional coordinate after correction of the alignment mark and a measured coordinate of the

alignment mark is set to be smaller than $tol_X$ and $tol_Y$.

However, it is not always possible to find a condition whereby the sum of squares of residuals $E_{Xi}$, $E_{Yi}$ in the related art alignment method is made minimum is sufficient to guarantee the possibility of attaining the maximum number of normal contact holes or a condition in which all contact holes are normally formed. In other words, the condition under which the sum of squares of residuals $E_{Xi}$, $E_{Yi}$ is made minimum does not always coincide with the most preferable correcting condition of the alignment in the manufacturing of the semiconductor device.

In turn, even if the sum of squares of the residuals $E_{Xi}$, $E_{Yi}$ is not made minimum, there is an alignment condition to provide the most preferable alignment result in the manufacturing of a semiconductor device. In particular, in the case where the random component in the displacement component of the alignment mark from the rational grid point does not follow a so-called normal distribution, the related art alignment method for making the sum of squares of residuals minimum is no longer preferable. However, in practice a normal deformation distribution is seldom found, since the wafer passes through various manufacturing processes such as film forming stage or etching or heat treatment processes, each generating complex and random deformation components.

As described above, the related art alignment method in which a sum of squares of the residuals $E_{Xi}$, $E_{Yi}$ is made minimum in order to make a minimum displacement between the position of the pattern to be formed in itself and the position of the pattern to be actually formed does not always provide the most preferable correcting condition of the alignment for the VLSI passed through various processes. This becomes particularly noticeable when the random component in the displacement component of the alignment marks from the rational grid point does not follow a normal distribution.

SUMMARY OF THE INVENTION

It is an object of the present invention to provide a new alignment method in which the alignment can be carried out with reference to the most preferable amount of correction by performing statistical processing based on a measuring position of the alignment mark even in the case where the random component in the displacement component of the alignment mark from a rational grid point does not follow a normal distribution.

As shown in Fig. 15B, the related art alignment method is carried out such that the difference between a position (the planned second pattern forming region) where the second pattern (a contact hole pattern) is to be originally formed and a position where the second pattern is actually formed, i.e. the positional displacements $\Delta X$ and $\Delta Y$ of the second pattern in the X and Y directions are treated as the residuals $E_{Xi}$, $E_{Yi}$, respectively.

$$E_{Xi} = \Delta X$$

$$E_{Yi} = \Delta Y$$

In Figs. 15 to 20, a layout relation between the first pattern and the second pattern is illustrated in order to facilitate its understanding. In these figures, the position where the second pattern (the contact hole pattern) is to be originally formed is equivalent to that of the point determined by a conversion operation of the rational grid point. In turn, the position where the second pattern is to be formed is equivalent to the position where an alignment mark related to the first pattern is measured.

In this related art alignment method, as described above, although it is easy to make an analytical calculation of a minimum value of sum of squares of the residuals, such a calculation does not always achieve the required alignment correction to form the patterns on the actual semiconductor device. In view of the above observation, the present invention employs a new method for evaluating displacement in the alignment with reference to the structure of the actual semiconductor device and a necessary condition to be satisfied for alignment work.

Specifically, an alignment method according to a first aspect of the present invention for accomplishing the aforesaid object involves a process for optically exposing a semiconductor device whereby after a resist is formed on the first pattern formed on the wafer, the resist is optically exposed to form the second pattern on the resist. Then, the position where the second pattern for the first pattern is to be formed is determined in response to the measurement of the positions of the alignment marks (N in number) associated with the first pattern formed on the wafer. Then, the alignment correction coefficients dx, dy, $\theta$, $\alpha$, $S_X$, $S_Y$ are first calculated by a method of least squares with reference to the coordinates ($X_{Mi}$, $Y_{Mi}$) of each of the alignment marks and the coordinates ($X_{Li}$, $Y_{Li}$) of the rational grid point corresponding to each of the alignment marks in the same manner as that of the related art alignment method.

After this operation, the corrected coordinates ($X_{Ti1}$, $Y_{Ti1}$) of the alignment marks are calculated with reference to the coordinates ($X_{Li}$, $Y_{Li}$) of the rational grid point corresponding to each of the alignment marks on the basis of the alignment mark correction coefficients and each of their random number elements. Then, the difference values:

$$\Delta_{Xi1} = X_{Mi} - X_{Ti1}$$

$$\Delta_{Yi1} = Y_{Mi} - Y_{Ti1}$$

are calculated and the residuals $E_{Xi1}$, $E_{Yi1}$ at each of the alignment marks are determined with reference to the following rule on the basis of the alignment displacement tolerance values $tol_X$ and $tol_Y$ in the predetermined X and Y directions which are alignment displacement values allowable in design of the semiconductor device.

(A) In the case where $|\Delta X_{i1}| \leqq tol_X$ and $|\Delta Y_{i1}| \leqq tol_Y$ are set :

$$E_{Xi1} = 0$$

$$E_{Yi1} = 0$$

(B) In the case where $|\Delta X_{i1}| > tol_X$ and $|\Delta Y_{i1}| > tol_Y$ are set :

$$E_{Xi1} = |\Delta X_{i1}| - tol_X$$

$$E_{Yi1} = |\Delta Y_{i1}| - tol_Y$$

(C) In the case where $|\Delta X_{i1}| \leqq tol_X$ and $|\Delta Y_{i1}| > tol_Y$ are set :

$$E_{Xi1} = 0$$

$$E_{Yi1} = |\Delta Y_{i1}| - tol_Y$$

(D) In the case where $|\Delta X_{i1}| > tol_X$ and $|\Delta Y_{i1}| \leqq tol_Y$ are set :

$$E_{Xi1} = |\Delta X_{i1}| - tol_X$$

$$E_{Yi1} = 0$$

Then, in view of these residuals $E_{Xi1}$, $E_{Yi1}$, a sum of residual squares $R_1 = \Sigma EX_{i1}^2 + \Sigma EY_{i1}^2$ is calculated.

Then, the aforesaid calculation stages are iterated a predetermined number of times with the alignment correction coefficients added with the random number elements being applied as new alignment correction coefficients. Lastly, the corrected coordinates ($X_{TiF}$, $Y_{TiF}$) of the alignment mark associated with the first pattern used for optically exposing the second pattern are calculated with reference to the alignment mark correction coefficients, and each of their random number elements satisfy the condition whereby the residual sum of squares $R1 = \Sigma EX_{i1}^2 + \Sigma EY_{i1}^2$ becomes a minimum value.

An alignment method according to a second aspect of the present invention will now be described in summary.

In the case where a pattern is to be formed in the semiconductor device by applying a reducing optical system, in particular, in the case where the formed pattern size approximately corresponds to the resolution limit of the reducing optical system, the pattern to be formed is substantially deformed from the design pattern. Accordingly, the allowable alignment displacement values required in performing a design of the semiconductor device must be set even more rationally in response to the pattern shape to be actually formed.

In the second alignment method of the present invention, the residuals $EX_{i1}$, $EY_{i1}$ at each of the alignment marks of the first alignment method are determined according to the following modified rules.

(A') In the case where $\Delta X_{i1}^2 + \Delta Y_{i1}^2 \leqq tol_X^2 + tol_Y^2$ :

$$EX_{i1} = 0$$

$$EY_{i1} = 0$$

(B') In the case where $\Delta X_{i1}^2 + \Delta Y_{i1}^2 > tol_X^2 + tol_Y^2$ :

$$EX_{i1}^{\ 2} + EY_{i1}^{\ 2} = \Delta X_{i1}^{\ 2} + \Delta Y_{i1}^{\ 2} - (tol_X^{\ 2} + tol_Y^{\ 2})$$

In the actual manufacturing process for the semiconductor device, displacements from the design pattern may easily occur due to various causes. In view of this fact, in the second alignment method of the present invention, it is preferable

that the allowable alignment displacement values are set for each of the regions every time they are set in response to the pattern shape of the first pattern actually formed.

Now, an alignment method according to a third aspect of the present invention will be described in summary.

There sometimes happens that the first pattern and the second pattern are already formed and a third pattern is concurrently formed with respect to these first and second patterns. In such a case as above, it is necessary that the allowable alignment displacement values are set with reference to the amount of alignment displacement between the lower layer patterns (between the first pattern and the second pattern) formed prior to the formation of the third pattern.

Thus, the optical exposure alignment method according to the third aspect of the invention is operative in a semiconductor device wherein a resist is formed on the first pattern and the second pattern is formed on the wafer, after which the resist is optically exposed to form the third pattern thereon as above, and the position where the third pattern with respect to the first pattern and the second pattern is determined in response to the measurement of the positions of the N alignment marks associated with the first pattern formed on the wafer. Then, the position of the alignment mark associated with the first pattern is measured and concurrently the position of the alignment mark associated with the second pattern is measured, and the amounts of alignment displacement $\Delta e_{x1}$, $\Delta e_{Yi}$ at each of the alignment marks are calculated with reference to a result of such measurement.

Then, the alignment correction coefficients dx, dy, $\theta$, $\alpha$, $S_X$ and $S_Y$ associated with the first pattern are calculated by a method of least squares with reference to the coordinates ($X_{Mi}$, $Y_{Mi}$) of each of the alignment marks and the coordinates ($X_{Li}$, $Y_{Li}$) of the rational grid point corresponding to each of the alignment marks as the related art alignment method.

After this operation, the correction coordinates ($X_{Ti1}$, $Y_{Ti1}$) of the alignment mark are calculated with reference to the coordinates ($X_{Li}$, $Y_{Li}$) of the rational grid point corresponding to each of the alignment marks on the basis of the alignment mark correction coefficients and each of the random number elements. Then, the difference values:

$$\Delta X_{i1} = X_{Mi} - X_{Ti1}$$

$$\Delta Y_{i1} = Y_{Mi} - Y_{Ti1}$$

are calculated.

Then, the new allowable alignment displacement values $tol_X'$ and $tol_Y'$in the X and Y directions are determined in accordance with the following rule on the basis of: the predetermined alignment displacement tolerance values $tol_X$, $tol_Y$ in the X and Y directions (which are alignment displacement values allowable in design of the semiconductor device), the predetermined alignment displacement values $\Delta e_{Xi}$, $\Delta e_{Yi}$, the above-mentioned values $\Delta X_{i1}$, $\Delta Y_{i1}$ in the case where the values of $tol_X'$, $tol_Y'$ are negative, they are assumed to be 0.

In the case of (x - 1)$\Delta e_{Xi} \geqq 0$ and $\Delta X_{i0} \geqq 0$ :

$$tol_X' = tol_X$$

In the case of (x - 2)$\Delta e_{Xi} \geqq 0$ and $\Delta X_{i0} < 0$ :

$$tol_X' = tol_X - |\Delta e_{xi}|$$

In the case of (x - 3)$\Delta e_{Xi} < 0$ and $\Delta X_{i0} \geqq 0$ :

$$tol_X' = tol_X - |\Delta e_{xi}|$$

In the case of (x - 4)$\Delta e_{Xi} < 0$ and $\Delta X_{i0} < 0$ :

$$tol_X' = tol_X$$

In the case of (y - 1)$\Delta e_{Yi} \geqq 0$ and $\Delta Y_{i0} \geqq 0$ :

$$tol_Y' = tol_Y$$

In the case of (y - 2)$\Delta e_{Yi} \geqq 0$ and $\Delta Y_{i0} < 0$ :

$$tol_Y' = tol_Y - |\Delta e_{Yi}|$$

In the case of (y - 3)$\Delta e_{Yi} < 0$ and $\Delta Y_{i0} \geqq 0$ :

$$tol_Y' = tol_Y - |\Delta e_{Yi}|$$

In the case of (y - 4)$\Delta e_{Yi} < 0$ and $\Delta Y_{i0} < 0$ :

$$tol_Y' = tol_Y$$

Then, the residuals $E_{Xi0}$, $E_{Yi0}$ at each of the alignment marks are determined in accordance with the following rule.

(A) In the case where $|\Delta X_{i1}| \leqq tol_X'$ and $|\Delta Y_{i1}| \leqq tol_Y'$ :

$$E_{Xi1} = 0$$

$$E_{Yi1} = 0$$

(B) In the case where $|\Delta X_{i1}| > tol_X'$ and $|\Delta Y_{i1}| > tol_Y'$ :

$$E_{Xi1} = |\Delta X_{i1}| - tol_X'$$

$$E_{Yi1} = |\Delta Y_{i1}| - tol_Y'$$

(C) In the case where $|\Delta X_{i1}| \leqq tol_X'$and $|\Delta Y_{i1}| > tol_Y'$ :

$$E_{Xi1} = 0$$

$$E_{Yi1} = |\Delta Y_{i1}| - tol_Y'$$

(D) In the case where $|\Delta X_{i1}| > tol_X'$ and $|\Delta Y_{i1}| \leqq tol_Y'$ :

$$E_{Xi1} = |\Delta X_{i1}| - tol_X'$$

$$E_{Yi1} = 0$$

Then, the residual sum of squares $R_1 = \Sigma E_{Xi1}{}^2 + \Sigma E_{Yi1}{}^2$ is calculated in reference to these residuals $E_{Xi1}$ and $E_{Yi1}$.

Then, the aforesaid steps are iterated a predetermined number of times with the alignment correction coefficients added with the random number elements being applied as new alignment correction coefficients. Lastly, the corrected coordinates ($X_{TiF}$, $Y_{TiF}$) of the alignment mark associated with the first pattern for use in optically exposing the third pattern are calculated with reference to the alignment mark correction coefficients and their random number elements when the residual sum of squares $R_1 = \Sigma E_{Xi1}{}^2 + \Sigma E_{Yi1}{}^2$ becomes a minimum value.

An alignment method according to a fourth aspect of the present invention is approximately similar to the second alignment method. That is, in the fourth alignment method of the present invention, the residuals $E_{Xi1}$ and $E_{Yi1}$ at each of the alignment marks in the third alignment method are determined by being changed in accordance with the following rule:

(A') In the case where $\Delta X_{i1}{}^2 + \Delta Y_{i1}{}^2 \leqq tol_X{}'^2 + tol_Y{}'^2$ :

$$EX_{i1} = 0$$

$$EY_{i1} = 0$$

(B') In the case where $\Delta X_{i1}{}^2 + \Delta Y_{i1}{}^2 > tol_X{}'^2 + tol_Y{}'^2$ :

$$EX_{i1}{}^2 + EY_{i1}{}^2 = \Delta X_{i1}{}^2 + \Delta Y_{i1}{}^2 - (tol_X{}'^2 + tol_Y{}'^2)$$

In the actual manufacturing process for a semiconductor device, a displacement from the design pattern may easily be generated due to various causes. In view of this fact, it is preferable in the fourth alignment method of the present invention that the alignment displacement tolerance value is set for each of the regions every time in response to the pattern shape of the already formed actual pattern.

In the alignment method of the present invention, the residuals $E_{Xi1}$, $E_{Yi1}$ are determined in response to the predetermined alignment displacement tolerances $tol_{Xi1}$, $tol_{Yi1}$ in the X and Y directions, respectively. Then, the most preferable values of the alignment correction coefficients dx, dy, $\theta$, $\alpha$, $S_X$ and $S_Y$ when the sum of residual squares $\Sigma E_{Xi1}{}^2 + \Sigma E_{Yi1}{}^2$ becomes minimum are calculated by an iterative solution. With such an arrangement as above, even if the random component in the displacement components of the alignment marks from the rational grid points does not follow the normal distribution, it is possible to obtain the most preferable amount of correction in the alignment.

Contact holes may be formed at any region of the semiconductor surface without problem, and their location may therefore be determined exactly so as to ensure a stable electrical contact. In the case that the displacement component of the alignment mark from the rational grid point follows the normal distribution, it is possible to obtain the most preferable

amount of correction in the alignment in such a way that the sum of residual squares may become minimum. Then, even in the case that a contact hole is formed in the region where an electrical contact can be stably assured, the most preferable amount of alignment correction is calculated in such a way that a residual between a rational forming position of the contact hole and a planned forming position of the contact hole can always approach 0. As a result, in the case where the random component in the displacement component in the alignment mark from the rational grid point does not follow the normal distribution, it sometimes happens that a contact hole is not formed in the region where the electrical contact can be stably assured under an alignment method based on the related art method of least squares, whereupon an erroneous optical exposure shot may be generated when the resist is optically exposed.

If the contact hole is formed in the region where an electrical contact can be stably assured, the contact hole may be formed at any region as above without giving rise to problems, whereupon the residuals $E_{Xi1}$, $E_{Yi1}$ in each of the alignment marks in the present invention are defined to be 0 in the case that $|\Delta X_{i1}| \leqq tol_X$ and $|\Delta Y_{i1}| \leqq tol_Y$ are attained. In turn, for example, in the case that $|\Delta X_{i1}| > tol_X$ and $|\Delta X_{i1}| > tol_Y$ are attained, the most preferable values of the alignment correction coefficients dx, dy, $\theta$, $\alpha$, $S_X$, $S_Y$ when the sum of residual squares $\Sigma E_{Xi1}{}^2 + \Sigma E_{Yi1}{}^2$ become minimum under a relation of $E_{Xi1} = |\Delta X_{i1}| - tol_X$ and $E_{Yi1} = |\Delta Y_{i1}| - tol_Y$, respectively, are calculated by the interactive solution.

BRIEF DESCRIPTION OF THE DRAWINGS

Fig. 1 is a general technical concept view for showing the related art alignment method;

Fig. 2 is a schematic illustration for showing a measuring point of an alignment mark, a rational grid point and a conversion of the rational grid point in the related art;

Figs. 3A and 3B are schematic illustrations for showing causes of deformation of the related art wafer;

Fig. 4A and 4B are schematic illustrations for showing causes of deformation of the related art wafer;

Fig. 5 is a flowchart for showing each of the steps in the alignment method in the first embodiment of the present invention;

Fig. 6 is a flowchart subsequent to Fig. 5 for showing each of the steps in the alignment method in the first embodiment of the present invention;

Fig. 7 is a flowchart subsequent to Fig. 6 for showing each of the steps of an alignment method in the first embodiment of the present invention;

Fig. 8 is a flowchart for showing each of the steps in a modified alignment method according to a second embodiment of the present invention;

Fig. 9 is a flowchart subsequent to Fig. 8 for showing each of the steps in a modified alignment method in the second embodiment of the present invention;

Fig. 10 is a flowchart subsequent to Fig. 8 for showing each of the steps in a modified alignment method in the second embodiment of the present invention;

Fig. 11 is a flowchart for showing each of the steps in the alignment method according to a third embodiment of the present invention;

Fig. 12 is a flowchart subsequent to Fig. 11 for showing each of the steps in the alignment method in the third embodiment of the present invention;

Fig. 13 is a flowchart subsequent to Fig. 12 for showing each of the steps in the alignment method in the third embodiment of the present invention;

Fig. 14 is a flowchart subsequent to Fig. 13 for showing each of the steps of the alignment method of the third embodiment of the present invention;

Figs. 15A and 15B are views for showing technical concepts of $\Delta X_{i1}$, $\Delta Y_{i1}$, $tol_X$, $tol_Y$ and residuals $E_{Xi1}$, $E_{Yi1}$ in the alignment method of the first embodiment of the present invention;

Figs. 16A and 16B are views for showing technical concepts of ΔXi1, $\Delta Y_{i1}$, $tol_X$, $tol_Y$ and residuals $E_{Xi1}$, $E_{Yi1}$ in the alignment method of the first embodiment of the present invention;

Fig. 17 is a view for showing technical concepts of $\Delta X_{i1}$, $\Delta Y_{i1}$, $tol_X$, $tol_Y$ and residuals $E_{Xi1}$, $E_{Yi1}$ in the alignment method of the first embodiment of the present invention;

Fig. 18 is a schematic illustration of the first pattern and the like formed close to the limiting degree of resolution of a reducing optical system;

Fig. 19 is a view for showing technical concepts of $\Delta X_{i1}$, $\Delta Y_{i1}$, $tol_X$, $tol_Y$ and residuals $E_{Xi1}$, $E_{Yi1}$ in the alignment method of the third embodiment of the present invention;

Fig. 20 is a view for showing technical concepts of $\Delta X_{i1}$, $\Delta Y_{i1}$, tolX, $tol_Y$ and residuals $E_{Xi1}$, $E_{Yi1}$ in the alignment method of the third embodiment of the present invention;

Fig. 21 is a view of a frequency distribution in displacement between positional coordinates ($X_{Mi}$, $Y_{Mi}$) of the alignment mark in the first pattern and coordinates ($X_{Li}$, $Y_{Li}$) of the rational grid points corresponding to each of the alignment marks before and after the alignment correction for showing a result of the first experiment in the first embodiment of the present invention;

Fig. 22 is a view of a frequency distribution in displacement of the corrected coordinates ($X_{TiF}$, $Y_{TiF}$) of each of the alignment marks from the coordinates (XLi, YLi) of the rational grid point corresponding to each of the alignment marks in the case where the alignment correction is carried out using the related art alignment method;

Fig. 23 is a view of a frequency distribution in the displacement of the corrected coordinates ($X_{TiF}$, $Y_{TiF}$) of each of the alignment marks from the coordinates ($X_{Li}$, $Y_{Li}$) of the rational grid point corresponding to each of the alignment marks in the case where the alignment correction is carried out with reference to an experimental result according to the first embodiment of the present invention;

Fig. 24 is a view of a frequency distribution in displacement of the corrected coordinates ($X_{TiF}$, $Y_{TiF}$) of each of the alignment marks from the coordinates ($X_{Li}$, $Y_{Li}$) of the rational grid point corresponding to each of the alignment marks in the case where the alignment correction is carried out through the related art alignment method different from that of Fig. 22; and

Fig. 25 is a view of a frequency distribution in displacement of the corrected coordinates ($X_{TiF}$, $Y_{TiF}$) of each of the alignment marks from the coordinates ($X_{Li}$, $Y_{Li}$) of the rational grid point corresponding to each of the alignment marks in the case where the alignment correction is carried out with reference to the result of the second experiment of the present invention.

## DETAILED DESCRIPTION OF THE PREFERRED EMBODIMENTS

The alignment method of the first embodiment of the present invention applies to an optical exposure method for a semiconductor device in which a resist is formed on a first pattern formed on a wafer. Thereafter the resist is optically exposed to form a second pattern on the resist, wherein the position where the second pattern is to be placed with respect to the first pattern is determined on the basis of a measurement of the positions of the alignment marks (number = N) associated with the first pattern formed on the wafer.

It is impossible or at least quite hard to perform an analytical and unconditional calculation for obtaining the alignment correction coefficients dx, dy, θ, α, $S_X$, $S_Y$ for minimizing a residual sum of squares $\Sigma E_{Xi1}{}^2 + \Sigma E_{Yi1}{}^2$ in response to the alignment displacements $E_{Xi1}$, $E_{Yi1}$ newly defined in the present invention. In addition, an optimization process for a continuous function under an assumption of a monotone decreasing down to a minimum value of the evaluation function such as the Newton method or a method of steepest descent cannot be applied, either due to the presence of a limitless number of local minimum values for the evaluation function. In view of this fact, the present invention proposes to calculate optimal values in the alignment correction coefficients dx, dy, θ, α, $S_X$, $S_Y$ by an iterative approach in which e.g. Monte Carlo method can be applied.

Referring now to the flowcharts of Figs. 5 to 7, each of the steps in the alignment method concerning the first embodiment of the present invention will be described more practically.

[Step-100]

Positions of N alignment marks associated with the first pattern are measured, and then the coordinates ($X_{Mi}$, $Y_{Mi}$) (where, i = 0, 1, 2 ..., N-1) of each of the alignment marks are calculated with reference to the result of such measurement. In this case, the appendix "i" designates the i-th alignment mark. Measurement of the alignment mark can be performed by applying an alignment mark sensing system of the TTL (Through The Lens) on-axis type, an alignment mark sensing system of the TTL off-axis type or an alignment mark sensing system of off-axis type.

[Step-110]

Defining:

- the error offsets of the alignment marks in the X and Y directions as dx and dy,
- the rotation of an error of the alignment mark in its rotating direction as θ,
- the error in the orthogonal degree in the layout in each of the alignment marks as α, and
- scalings (which are variations in magnification of the alignment marks in the X and Y directions) as $S_X$, $S_Y$,

then the alignment correction coefficients dx, dy, θ, α, $S_X$, $S_Y$ are calculated by a method of least squares based on the following equations (1) and (2) with reference to the coordinates ($X_{Mi}$, $Y_{Mi}$) of each of the alignment marks and the coordinates ($X_{Li}$, $Y_{Li}$) of the rational grid point corresponding to each of the alignment marks. This process is similar to the related art alignment method.

$$\begin{pmatrix} \sum_{i=0}^{N-1} X_{Li}^2 & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^2 & \sum_{i=0}^{N-1} Y_{Li} \\ \sum_{i=0}^{N-1} X_{Li} & \sum_{i=0}^{N-1} Y_{Li} & \sum_{i=0}^{N-1} i \end{pmatrix} \begin{pmatrix} a \\ b \\ c \end{pmatrix} = \begin{pmatrix} \sum_{i=0}^{N-1} X_{Mi}X_{Li} \\ \sum_{i=0}^{N-1} X_{Mi}Y_{Li} \\ \sum_{i=0}^{N-1} X_{Mi} \end{pmatrix}$$

Equation (1)

$$\begin{pmatrix} \sum_{i=0}^{N-1} X_{Li}^2 & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^2 & \sum_{i=0}^{N-1} Y_{Li} \\ \sum_{i=0}^{N-1} X_{Li} & \sum_{i=0}^{N-1} Y_{Li} & \sum_{i=0}^{N-1} i \end{pmatrix} \begin{pmatrix} d \\ e \\ f \end{pmatrix} = \begin{pmatrix} \sum_{i=0}^{N-1} Y_{Mi}X_{Li} \\ \sum_{i=0}^{N-1} Y_{Mi}Y_{Li} \\ \sum_{i=0}^{N-1} Y_{Mi} \end{pmatrix}$$

$$a = 1 + S_X$$
$$b = \alpha + \theta$$
$$c = dx$$
$$d = -\theta$$
$$e = 1 + S_Y$$
$$f = dy$$

Equation (2)

The concepts of these alignment correction coefficients dx, dy, $\theta$, $\alpha$, $S_X$, $S_Y$ are as indicated in Figs. 3 and 4. In addition, the alignment correction coefficients dx, dy, $\theta$, $\alpha$, $S_X$, $S_Y$ are used as the initial values in the following steps.

A proper value is set in advance as a residual sum of squares used in the following steps.

[Step-120]

Next, the random number elements $\Delta dx$, $\Delta dy$, $\Delta\theta$, $\Delta\alpha$, $\Delta S_X$, $\Delta S_Y$ associated with each of the alignment correction coefficients dx, dy, $\theta$, $\alpha$, $S_X$, $S_Y$ are generated. Then, the correction coordinates ($X_{Ti1}$, $Y_{Ti1}$) of the alignment mark are calculated with reference to the following equation (3) on the basis of the alignment correction coefficients dx, dy, $\theta$, $\alpha$, $S_X$, $S_Y$ and each of the random number elements $\Delta dx$, $\Delta dy$, $\Delta\theta$, $\Delta\alpha$, $\Delta S_X$, $\Delta S_Y$.

$$\begin{pmatrix} X_{Ti1} \\ Y_{Ti1} \end{pmatrix} = \begin{pmatrix} 1+S_x+\Delta S_x & \alpha+\Delta\alpha+\theta+\Delta\theta \\ -(\theta+\Delta\theta) & 1+S_y+\Delta S_y \end{pmatrix} \begin{pmatrix} X_{Li} \\ Y_{Li} \end{pmatrix} + \begin{pmatrix} dx+\Delta dx \\ dy+\Delta dy \end{pmatrix}$$

Equation (3)

In this equation, each of the random number elements is a normal random number and determined by a computer in reference to some experimental data on the basis of trial-and-error manner. In general, the correction coordinates ($X_{Ti1}$, $Y_{Ti1}$) of the alignment marks obtained from the above equation (9) and the residual sum of squares $R_1$ obtained by the following steps are deteriorated more than the residual sum of squares $R_1$ obtained by the equation (3) and the following steps with all the random number elements $\Delta dx$, $\Delta dy$, $\Delta\theta$, $\Delta\alpha$, $\Delta S_X$, $\Delta S_Y$ being set to be 0 if the distribution range of the random number elements is too wide. In turn, if the distribution range of the random number elements is too narrow, the residual sum of squares R1 obtained by the following steps is improved, although a speed of conversion toward the most preferable value becomes quite slow, resulting in time expenditure.

[Step-130]

Next, the following difference values are calculated :

$$\Delta X_{i1} = X_{Mi} - X_{Ti1}$$

$$\Delta Y_{i1} = Y_{Mi} - Y_{Ti1}$$

In addition, each of the values of alignment displacements (alignment displacement tolerances) $tol_X$, $tol_Y$ which can be allowed in the design of a semiconductor device is set in advance in each of the X and Y directions, respectively. The residuals $E_{Xi1}$, $E_{Yi1}$ at each of the alignment marks are determined in response to such values $tol_X$, $tol_Y$, respectively, in accordance with the following rule.

(A) In the case where $|\Delta X_{i1}| \leqq tol_X$ and $|\Delta Y_{i1}| \leqq tol_Y$ (refer to Fig. 15B) :

$$E_{Xi1} = 0$$

$$E_{Yi1} = 0$$

That is, the alignment displacements within the set alignment displacement tolerances (tolX, tolY) are set to be 0 and equally handled. This is justified by the fact that there occurs no problem in view of an actual structure of a semiconductor device for any pattern of positional displacement generated within the range of the alignment displacement tolerances. In other words, $tol_X$ and $tol_Y$ are set in such a way that there occurs no problem in view of an actual structure of a semiconductor device irrespective of pattern of positional displacement within the range of alignment displacement tolerances.

(B) In the case where $|\Delta X_{i1}| > tol_X$ and $|\Delta Y_{i1}| > tol_Y$ (refer to Fig. 16A) :

$$E_{Xi1} = |\Delta Xi1| - tol_X$$

$$E_{Yi1} = |\Delta Yi1| - tol_Y$$

That is, the alignment displacement values exceeding the alignment displacement tolerances ($tol_X$, $tol_Y$) are defined as alignment displacements.

(C) In the case where $|\Delta X_{i1}| \leqq tol_X$ and $|\Delta Y_{i1}| > tol_Y$ (refer to Fig. 16B) :

$$E_{Xi1} = 0$$

$$E_{Yi1} = |\Delta Y_{i1}| - tol_Y$$

(D) In the case where $|\Delta X_{i1}| > tol_X$ and $|\Delta Y_{i1}| \leqq tol_Y$ (refer to Fig. 17) :

$$E_{Xi1} = |\Delta X_{i1}| - tol_X$$

$$E_{Yi1} = 0$$

[Step-140]

The residual sum of squares $R_1$ is calculated with reference to these residuals $E_{Xi1}$, $E_{Yi1}$ on the basis of the following equation (4) and in the case where the calculated residual sum of squares $R_1$ is smaller than the residual sum of squares $R_0$, $R_1$ is defined as a new $R_0$.

$$R_1 = \sum_{i=0}^{N-1} E_{Xi1}^2 + \sum_{i=0}^{N-1} E_{Yi1}^2$$

Equation (4)

[Step-150]

Steps [step-120] to [step-140] are repeated by a plurality of times while the alignment correction coefficients dx, dy, $\theta$, $\alpha$, $S_X$, $S_Y$ added with random number elements $\Delta dx$, $\Delta dy$, $\Delta\theta$, $\Delta\alpha$, $\Delta S_X$, $\Delta S_Y$ are being applied as new alignment correction coefficients dx, dy, $\theta$, $\alpha$, $S_X$, $S_Y$. That is, steps [step-120] to [step-140] are repeated a plurality of times while each of $dx+\Delta dx$, $dy+\Delta dy$, $\theta+\Delta\theta$, $\alpha+\Delta\alpha$, $S_X+\Delta S_X$, $S_Y+\Delta S_Y$ is applied as new alignment correction coefficients dx, dy, $\theta$, $\alpha$, $S_X$, $S_Y$.

[Step-160]

Next, the corrected coordinates ($X_{TiF}$, $Y_{TiF}$) of the alignment mark associated with the first pattern for optically exposing the second pattern are calculated by the following equation (5) on the basis of the alignment correction coefficients dx, dy, θ, α, $S_X$, $S_Y$ when the minimum residual sum of squares $R_1$ and each of the random number elements Δdx, Δdy, Δθ, Δα, $\Delta S_X$, $\Delta S_Y$ are obtained.

$$\begin{pmatrix} X_{TIF} \\ Y_{TIF} \end{pmatrix} = \begin{pmatrix} 1+S_x+\Delta S_x & \alpha+\Delta\alpha+\theta+\Delta\theta \\ -(\theta+\Delta\theta) & 1+S_y+\Delta S_y \end{pmatrix} \begin{pmatrix} X_{LI} \\ Y_{LI} \end{pmatrix} + \begin{pmatrix} dx+\Delta dx \\ dy+\Delta dy \end{pmatrix}$$

Equation (5)

After this operation, the wafer stage is moved on the basis of the corrected coordinates ($X_{TiF}$, $Y_{TiF}$) of the calculated alignment mark, and the resist formed on the first pattern is optically exposed by applying a reticle having the second pattern formed thereon.

In [Step-150], the wording of "repeated by a plurality of times" not only means a repetition of [step-120] to [step-140] a predetermined number of times, but also includes the case in which a repetition of [step-120] to [step-140] is performed until the residual sum of squares takes an approximate minimum value or becomes 0. That is, in the case where the value of $\Sigma E_{Xi1}{}^2 + \Sigma E_{Yi1}{}^2$ calculated at present time becomes smaller than the value of $\Sigma E_{Xi1}{}^2 + \Sigma E_{Yi1}{}^2$ calculated in the previous step, the repetition includes [step-120] to [step-140], and these steps are repeated until the residual sum of squares $\Sigma E_{Xi1}{}^2 + \Sigma E_{Yi1}{}^2$ takes an approximate minimum value or becomes 0. The approximate minimum value defined in this case is meant by a minimum value obtained in a combination of all given variables (dx, dy, θ, α, $S_X$, $S_Y$). More practically, it is satisfactory that the minimum value of the residual sum of squares $\Sigma E_{Xi1}{}^2 + \Sigma E_{Yi1}{}^2$ finally obtained is sufficiently improved as compared with a local minimum value which is most approximate to the initial value and further the minimum value of $\Sigma E_{Xi1}{}^2 + \Sigma E_{Yi1}{}^2$ finally obtained by itself can be sufficiently attained.

In the case where the residual sum of squares $R_1$ calculated in the [step-140] is the same as the residual sum of squares $R_0$ and that the residual sum of squares $R_1$ is smaller than the residual sum of squares $R_0$ under application of the original alignment correction coefficients dx, dy, θ, α, $S_X$, $S_Y$ not added with the random number elements Δdx, Δdy, Δθ, Δα, $\Delta S_X$, $\Delta S_Y$, [step-120] to [step-140] may be repeated a plurality of times with the alignment correction coefficients dx, dy, θ, α, $S_X$, $S_Y$ added with the random number elements Δdx, Δdy, Δθ, Δα, $\Delta S_X$, $\Delta S_Y$, being applied as new alignment correction coefficients dx, dy, θ, α, $S_X$, $S_Y$.

In Figs. 8 to 10 are shown flowcharts of a second embodiment of the present invention, i.e. a modified form of the first alignment method.

The pattern to be formed in this case is remarkably deformed from its design pattern, as may occur when the pattern in a semiconductor device is produced by means of a reducing optical system, in particular, when its forming pattern corresponds approximately to the resolution limit of the reducing optical system.

For example, even in case of the pattern to be designed in reference to the alignment displacement as shown in Fig. 15, the first pattern is deformed and differs from that of the first pattern as shown in Fig. 18 near the limiting resolution in the reducing optical system to be used. In this case, the alignment displacement tolerance for forming the normal second pattern (for example, a contact hole pattern) is defined as

$$\Delta X^2 + \Delta Y^2 < tol^2 = tol_X{}^2 + tol_Y{}^2$$

Accordingly, the evaluation of the alignment displacement in this case modifies the residuals $E_{Xi1}$, $E_{Yi1}$ in each of the alignment marks in [step-130] concerning the first embodiment of the present invention and determine them in accordance with the following rule.

(A') In the case that $\Delta X_{i1}{}^2 + \Delta Y_{i1}{}^2 \leqq tol_X{}^2 + tol_Y{}^2 = tol^2$

$$E_{Xi1} = 0$$

$$E_{Yi1} = 0$$

(B') In the case that $\Delta X_{i1}{}^2 + \Delta Y_{i1}{}^2 > tol_X{}^2 + tol_Y{}^2 = tol^2$

$$E_{Xi1}{}^2 + E_{Yi1}{}^2 = \Delta X_{i1}{}^2 + \Delta Y_{i1}{}^2 - (tol_X{}^2 + tolY^2)$$

Unless otherwise specified, since the alignment method of the second embodiment of the present invention can be set to be similar to the alignment method of the first embodiment of the present invention, its detailed description will be eliminated. As described above, it is satisfactory that the alignment correction coefficients dx, dy, $\theta$, $\alpha$, $S_X$, $S_Y$ are set to be optimal in such a way that the residual sum of squares of the alignment displacement is made to be minimum with the aforesaid condition (B') being applied as the alignment displacement.

In the practical manufacturing process for a semiconductor device, a displacement from a design pattern may easily be generated due to various causes. In view of this fact, it is preferable that the alignment displacement tolerance values in the present invention can be set for each of the regions every time on the basis of the pattern shape of the first pattern actually formed.

The third embodiment of the present invention will now be described.

There occurs sometimes that the first pattern and the second pattern are already formed and then the third pattern is formed concurrently with respect to these first and second patterns. In such a case as above, it is necessary to set the alignment displacement tolerances in view of the amount of alignment displacement between the lower layer patterns (between the first pattern and the second pattern) formed prior to the formation of the third pattern. As shown in Figs. 19 and 20, it is assumed that the alignment is carried out in order to form the two contact holes which are in the third pattern in respect to the first pattern and the second pattern.

In the third embodiment, optical exposure is carried out on a semiconductor device in which a resist is formed on the first and second patterns formed on the wafer and then the resist is optically exposed to form the third pattern on the resist, wherein a position where the third pattern against the first pattern and the second pattern is determined on the basis of a measurement of positions of the N alignment marks associated with the first pattern formed on the wafer.

Thus, at first, the alignment for the second pattern is carried out for the first pattern so as to form the second pattern. Then, in the case where alignment is carried out for the first pattern so as to form the third pattern (for example, a contact hole pattern), the alignment method of the third embodiment of the present invention is applied. Referring now to the flow charts shown in Figs. 11 to 14, the alignment method of the third embodiment of the present invention will be described.

[Step-300]

At first, positions of the N alignment marks associated with the first pattern are measured and then the coordinates ($X_{Mi}$, $Y_{Mi}$) (where, i = 0, 1, 2, ..., N-1) of each of the alignment marks are calculated in reference to the result of measurement.

[Step-310]

In turn, positions of the N alignment marks associated with the second pattern are measured and then the coordinates ($X_{Mi2}$, $Y_{Mi2}$) of each of the alignment marks is calculated in reference to the result of measurement.

The measurement of these alignment marks can be carried out by applying an alignment mark sensing system of the TTL on-axis method, an alignment mark sensing system of the TTL off-axis method and an alignment mark sensing system of the off-axis method, respectively.

[Step-320]

Alignment displacement amounts $\Delta e_{Xi}$, $\Delta e_{Yi}$ in each of the alignment marks are calculated in reference to the following equations (6-1) and (6-2), respectively.

$$\Delta e_{Xi} = X_{Mi2} - X_{Mi} \quad \text{Equation (6-1)}$$

$$\Delta e_{Yi} = Y_{Mi2} - Y_{Mi} \quad \text{Equation (6-2)}$$

[Step-330]

Next, defining

- the offsets of error of the alignment marks associated with the first pattern in the X and Y directions as dx, dy;
- the rotation of an error in the alignment mark associated with the first pattern in its rotating direction as $\theta$;

- the orthogonal degree of layout of an error in an orthogonal degree at the layout of each of the alignment marks associated with the first pattern as $\alpha$; and
- scalings of variation in magnification of the alignment marks associated with the first pattern in the directions as $S_X$, $S_Y$,

then the alignment correction coefficients dx, dy, $\theta$, $\alpha$, $S_X$, $S_Y$ are calculated by a method of least squares on the basis of the following equations (1) and (2) in reference to the coordinates ($X_{Mi}$, $Y_{Mi}$) of each of the alignment marks associated with the first pattern and the coordinates ($X_{Li}$, $Y_{Li}$) of the rational grid point corresponding to each of the alignment marks. This step is similar to the related art alignment method.

$$\begin{pmatrix} \sum_{i=0}^{N-1} X_{Li}^2 & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^2 & \sum_{i=0}^{N-1} Y_{Li} \\ \sum_{i=0}^{N-1} X_{Li} & \sum_{i=0}^{N-1} Y_{Li} & \sum_{i=0}^{N-1} i \end{pmatrix} \begin{pmatrix} a \\ b \\ c \end{pmatrix} = \begin{pmatrix} \sum_{i=0}^{N-1} X_{Mi}X_{Li} \\ \sum_{i=0}^{N-1} X_{Mi}Y_{Li} \\ \sum_{i=0}^{N-1} X_{Mi} \end{pmatrix}$$

Equation (1)

$$\begin{pmatrix} \sum_{i=0}^{N-1} X_{Li}^2 & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^2 & \sum_{i=0}^{N-1} Y_{Li} \\ \sum_{i=0}^{N-1} X_{Li} & \sum_{i=0}^{N-1} Y_{Li} & \sum_{i=0}^{N-1} i \end{pmatrix} \begin{pmatrix} d \\ e \\ f \end{pmatrix} = \begin{pmatrix} \sum_{i=0}^{N-1} Y_{Mi}X_{Li} \\ \sum_{i=0}^{N-1} Y_{Mi}Y_{Li} \\ \sum_{i=0}^{N-1} Y_{Mi} \end{pmatrix}$$

Equation (2)

where

$$a = 1 + S_X$$
$$b = \alpha + \theta$$
$$c = d x$$
$$d = -\theta$$
$$e = 1 + S_Y$$
$$f = d y$$

The technical concept behind these alignment correction coefficients dx, dy, $\theta$, $\alpha$, $S_X$, $S_Y$ is as shown in Figs. 3 and 4. In addition, these alignment correction coefficients dx, dy, $\theta$, $\alpha$, $S_X$, $S_Y$ are applied as the initial values in the following steps.

A proper value is set in advance as the residual sum of squares $R_0$ to be used in the following steps.

[Step-340]

Then, random number elements $\Delta$dx, $\Delta$dy, $\Delta\theta$, $\Delta\alpha$, $\Delta S_X$, $\Delta S_Y$ associated with each of the alignment correction coefficients dx, dy, $\theta$, $\alpha$, $S_X$, $S_Y$ are generated. Then, the correction coordinates ($X_{Ti1}$, $Y_{Ti1}$) of the alignment mark are calculated with reference to the following equation (3) on the basis of the alignment correction coefficients dx, dy, $\theta$, $\alpha$, $S_X$, $S_Y$ and each of the random number elements $\Delta$dx, $\Delta$dy, $\Delta\theta$, $\Delta\alpha$, $\Delta S_X$, $\Delta S_Y$. Each of the random number elements is a normal random number.

$$\begin{pmatrix} X_{Ti1} \\ Y_{Ti1} \end{pmatrix} = \begin{pmatrix} 1+S_x+\Delta S_x & \alpha+\Delta\alpha+\theta+\Delta\theta \\ -(\theta+\Delta\theta) & 1+S_y+\Delta S_y \end{pmatrix} \begin{pmatrix} X_{Li} \\ Y_{Li} \end{pmatrix} + \begin{pmatrix} dx+\Delta dx \\ dy+\Delta dy \end{pmatrix}$$

Equation (3)

[Step-350]

Then, the following difference values are calculated:

$$\Delta X_{i1} = X_{Mi} - X_{Ti1}$$

$$\Delta Y_{i1} = Y_{Mi} - X_{Ti1}$$

[Step-360]

Then, alignment displacement tolerance values $tol_X'$ and $tol_Y'$ in the new X and Y directions are determined in accordance with the following rule on the basis of the alignment displacement tolerances $tol_X$, $tol_Y$ set for each of the directions X, Y which are alignment displacement values allowable in design of a semiconductor device, alignment displacement amounts $\Delta e_{Xi}$, $\Delta e_{Yi}$ calculated at [step-320] and $\Delta X_{i1}$, $\Delta Y_{i1}$ calculated at the [step-350]. When the values of $tol_X'$ and toly' are negative, they are assumed to be 0.

In the case where (x - 1)$\Delta e_{Xi} \geqq 0$ and $\Delta X_{i0} \geqq 0$ :

$$tol_X' = tol_X$$

In the case where (x - 2)$\Delta e_{Xi} \geqq 0$ and $\Delta X_{i0} < 0$ :

$$tolX' = tol_X - |\Delta e_{Xi}|$$

In the case where (x - 3)$\Delta e_{Xi} < 0$ and $\Delta X_{i0} \geqq 0$:

$$tol_X' = tol_X - |\Delta e_{Xi}|$$

In the case where (x - 4)$\Delta e_{Xi} < 0$ and $\Delta X_{i0} < 0$ :

$$tol_X' = tol_X$$

In the case where (y - 1)$\Delta e_{Yi} \geqq 0$ and $\Delta Y_{i0} \geqq 0$ :

$$tol_Y' = tol_Y$$

In the case where (y - 2)$\Delta e_{Yi} \geqq 0$ and $\Delta Y_{i0} < 0$ :

$$tol_Y' = tol_Y - |\Delta e_{Yi}|$$

In the case where (y - 3)$\Delta e_{Yi} < 0$ and $\Delta Y_{i0} \geqq 0$ :

$$tol_Y' = tol_Y - |\Delta e_{Yi}|$$

In the case where $(y - 4)\Delta e_{Yi} < 0$ and $\Delta Y_{i0} < 0$ :

$$tol_Y' = tol_Y$$

[Step-370]

The residuals $E_{Xi1}$, $E_{Yi1}$ at each of the alignment marks associated with the first pattern are determined on the basis of $tol_X'$ and $tol_Y'$ in accordance with the following rule:

(A) In the case that $|\Delta Xi1| \leqq tol_X'$ and $|\Delta Y_{i1}| \leqq tol_Y'$

$$E_{Xi1} = 0$$

$$E_{Yi1} = 0$$

Thus, the alignment displacements within the set alignment displacement tolerances are assumed to be 0 and they are equally treated. This is explained by the fact that there is no problem in view of the actual structure of the semiconductor device whatever type of pattern positional displacement may occur within the alignment displacement tolerances. In other words, $tol_X$, $tol_Y$ are set in such a manner that there occurs no problem in view of a structure of a semiconductor device whatever pattern positional displacement may occur within the alignment displacement tolerances.

(B) In the case where $|\Delta X_{i1}| > tol_X'$ and $|\Delta Y_{i1}| > tol_Y'$ :

$$E_{Xi1} = |\Delta X_{i1}| - tol_X$$

$$EY_{i1} = |\Delta Y_{i1}| - tol_Y'$$

That is, the alignment displacement value exceeding the alignment displacement tolerance values ($tol_X'$, $tol_Y'$) is defined as an alignment displacement.

(C) In the case where $|\Delta X_{i1}| \leqq tol_X'$ and $|\Delta Y_{i1}| > tol_Y'$ :

$$E_{Xi1} = 0$$

$$E_{Yi1} = |\Delta Y_{i1}| - tol_Y'$$

(D) In the case where $|\Delta X_{i1}| > tol_X'$ and $|\Delta Y_{i1}| \leqq tol_Y'$ :

$$EXi1 = |\Delta Xi1| - tolX$$

$$EYi1 = 0$$

In actual practice, as shown in Fig. 19, it is assumed that there occurs an alignment only by $\Delta e_{Xi}$ in respect to the direction X when the second pattern is formed. That is,

$$\Delta e_{Xi} = X_{Mi2} - X_{Mi}$$

where, $X_{Mi2}$ is an X coordinate of a position of the alignment mark associated with the second pattern, and $X_{Mi}$ is an X coordinate of a position of the alignment mark associated with the first pattern. The alignment displacement tolerance value for satisfying a necessary condition (a necessary condition for forming a normal third pattern) for forming a semiconductor device is reduced only by $|\Delta e_{Xi}|$ with respect to the minus direction of $\Delta X_{i1} (= X_{Mi} - X_{Ti1})$ due to this alignment displacement.

That is, in the case that $\Delta e_{Xi} \geqq 0$ and $\Delta X_{i1} \geqq 0$,

$$tol_X' = tol_X$$

and in turn, in the case that $\Delta e_{Xi} \geqq 0$ and $\Delta X_{i1} < 0$,

$$tol_X' = tol_X - |\Delta e_{Xi}|$$

becomes a new alignment displacement tolerance value.

In turn, as shown in Fig. 20, it is assumed that the alignment displacement occurs only by $-\Delta e_{Xi}$ in respect to the direction X when the second pattern is formed. The alignment displacement tolerance value for satisfying a necessary condition (a necessary condition for forming a normal third pattern) required in formation of a semiconductor device is

reduced only by $|\Delta e_{Xi}|$ in regard to the plus direction of $\Delta X_{i1}$ (= $X_{Mi} - X_{Ti1}$) due to this alignment displacement.

That is, in the case where $\Delta e_{Xi} < 0$ and $\Delta X_{i1} < 0$,

$$tol_X' = tol_X$$

and in turn, in the case where $\Delta e_{Xi} < 0$ and $\Delta X_{i1} \geqq 0$, then

$$tol_X' = tol_X - |\Delta e_{Xi}|$$

becomes a new alignment displacement tolerance value.

Then, it is satisfactory that the alignment correction coefficients dx, dy, θ, α, $S_X$, $S_Y$ are made the optimal values such that the residual sum of squares of the alignment displacement becomes a minimum with the above new alignment displacement tolerance applied as an alignment displacement.

Even in the case where an alignment displacement is generated only by $\Delta e_{Yi}$ in the Y direction when the second pattern is formed, it is satisfactory that this may be processed in the same manner as in the aforesaid process.

[Step-380]

The residual sum of squares $R_1$ is calculated in accordance with equation (4) below with reference to these residuals $E_{Xi1}$, $E_{Yi1}$ and when the calculated residual sum of squares $R_1$ is smaller than the residual sum of squares $R_0$, $R_1$ is set to be a new $R_0$.

$$R_1 = \sum_{i=0}^{N-1} E_{Xi1}^2 + \sum_{i=0}^{N-1} E_{Yi1}^2$$

Equation (4)

[Step-385]

Steps [step-340] to [step-380] are repeated a plurality of times with the alignment correction coefficients dx, dy, θ, α, $S_X$, $S_Y$ added with the random number elements Δdx, Δdy, Δθ, Δα, $\Delta S_X$, $\Delta S_Y$ being applied as new alignment correction coefficients dx, dy, θ, α, $S_X$, $S_Y$. That is, [step-340] to [step-380] are repeated a predetermined number of times with each of dx+Δdx, dy+Δdy, θ+Δθ, α+Δα, $S_X+\Delta S_X$, $S_Y+\Delta S_Y$ applied as new alignment correction coefficients dx, dy, θ, α, $S_X$, $S_Y$. The technical concept of repeating processing a plurality of times is similar to that already described in reference to the alignment method in the first embodiment of the present invention.

Similarly to the case in which a modified form of alignment method in the first embodiment has already been described, in the case where the residual sum of squares $R_1$ calculated at [step-380] is the same or larger than the residual sum of squares $R_0$, the original alignment correction coefficients dx, dy, θ, α, $S_X$, $S_Y$ not added with the random number elements Δdx, Δdy, Δθ, Δα, $\Delta S_X$, $\Delta S_Y$ are applied. In turn, where the residual sum of squares $R_1$ is smaller than the residual sum of squares $R_0$, [step-340] to [step-380] can also be performed a plurality of times with the alignment correction coefficients dx, dy, θ, α, $S_X$, $S_Y$ added by the random number elements Δdx, Δdy, Δθ, Δα, $\Delta S_X$, $\Delta S_Y$ applied as new alignment correction coefficients dx, dy, θ, α, $S_X$, $S_Y$.

[Step-390]

Next, the corrected coordinates ($X_{TiF}$, $Y_{TiF}$) of alignment mark associated with the first pattern for optically exposing the third pattern are calculated using equation (5) below on the basis of the alignment correction coefficients dx, dy, θ, α, $S_X$, $S_Y$ and each of the random number elements Δdx, Δdy, Δθ, Δα, ΔSX, $\Delta S_Y$ when the minimum residual sum of squares $R_1$ is attained.

$$\begin{pmatrix} X_{TiF} \\ Y_{TiF} \end{pmatrix} = \begin{pmatrix} 1+S_x+\Delta S_x & \alpha+\Delta\alpha+\theta+\Delta\theta \\ -(\theta+\Delta\theta) & 1+S_y+\Delta S_y \end{pmatrix} \begin{pmatrix} X_{Li} \\ Y_{Li} \end{pmatrix} + \begin{pmatrix} dx+\Delta dx \\ dy+\Delta dy \end{pmatrix}$$

Equation (5)

A fourth embodiment of the present invention will now be described.

When a pattern in a semiconductor device is formed by applying an optical size reducing system, especially when

the size of its forming pattern approaches the resolution limit of the optical size reducing system, the pattern to be formed is substantially deformed from its design pattern. Accordingly, even in the alignment method of the third embodiment of the present invention, the alignment displacement tolerance values required in design of the semiconductor device must be set more rationally in response to the pattern shape to be actually formed.

In the alignment method according to the fourth embodiment of the present invention, the residuals $E_{Xi1}$, $E_{Yi1}$ of each of the alignment marks in [step-370] of the alignment method of the third embodiment are determined by being modified into the following rule. Apart from this point, the alignment method of the fourth embodiment is similar to the alignment method of the third embodiment, and a detailed description of the common aspects shall be omitted.

(A') In the case where $\Delta X_{i1}^2 + \Delta Y_{i1}^2 \leqq tol_X'^2 + tol_Y'^2 = tol^2$:

$$E_{Xi1} = 0$$

$$E_{Yi1} = 0$$

(B') In the case where $\Delta X_{i1}^2 + \Delta Y_{i1}^2 > tol_X'^2 + tol_Y'^2 = tol^2$:

$$E_{Xi1}^2 + E_{Yi1}^2 = \Delta X_{i1}^2 + \Delta Y_{i1}^2 - (tol_X'^2 + tol_Y'^2)$$

In the actual manufacturing process for a semiconductor device, a displacement from the design pattern may easily be generated due to various causes. In view of this fact, it is desirable according to the fourth embodiment of the invention that the alignment displacement tolerance values are set every time for each of the regions in reference to the pattern shape of the pattern actually formed.

An example of an experimental implementation of the present invention will be indicated.

A practical example under application of the alignment method of the first preferred embodiment of the present invention will be described. Alignment conditions are set as follows.

| | |
|---|---|
| Wafer size : | 8 inches |
| Step pitch (chip size) : | 20000 μm |
| Number of shots : | 9 x 9 (81) |
| Alignment mark sampling : | 81 locations |

In Fig. 21 is shown a frequency distribution figure of displacements (residuals) between the positional coordinates ($X_{Mi}$, $Y_{Mi}$) of the measured data of the alignment mark of the first pattern (a base pattern) before correction of alignment and the coordinates ($X_{Li}$, $Y_{Li}$) of the rational grid point corresponding to each of the alignment marks. In this case, their values are as follows.

$X_{ave}$ = 0.060968 μm
$\alpha X$ = 0.024363 μm
$X_{min}$ = 0.015640 μm
$X_{max}$ = 0.138800 μm
$Y_{ave}$ = 0.065258 μm
$\sigma Y$ = 0.029341 μm
$Y_{min}$ = 0.024760 μm
$Y_{max}$ = 0.146200 μm

Feature of these measured data consists in the fact that an alignment displacement distribution is not symmetrical in the lateral direction, i.e. it is not in accordance with the normal distribution.

In Fig. 22 is shown a frequency distribution of a displacement (residual) of the corrected coordinates ($X_{TiF}$, $Y_{TiF}$) of each of the alignment marks from the coordinates ($X_{Li}$, $Y_{Li}$) of the rational grid point corresponding to each of the alignment marks after the above-described first pattern is corrected in its alignment using the related art alignment method. In this case, the alignment correction coefficients are optimized by a least squares method in such a way that the residual sum of squares may become minimum. The result of the optimal formation of the alignment correction coefficients with the related art alignment method is as follows.

dx = $6.022231 \times 10^{-2}$ μm
dy = $6.471484 \times 10^{-2}$ μm
$\theta$ = $5.093068 \times 10^{-8}$ rad

$\alpha = 1.141213 \times 10^{-7}$ rad

$S_X = 3.964432 \times 10^{-8}$

$S_Y = 1.897899 \times 10^{-7}$

In this case, the position parameters showed the following values.

$X_{ave} = 0.000746$ µm

$\sigma X = 0.022712$ µm

$X_{min} = -0.028207$ µm

$X_{max} = 0.079500$ µm

$Y_{ave} = 0.000820$ µm

$\sigma Y = 0.027326$ µm

$Y_{min} = -0.036042$ µm

$Y_{max} = 0.066302$ µm

As is apparent from the frequency distribution figure shown in Fig. 22, the maximum and minimum values of the alignment displacement are distributed non-symmetrically. If the alignment displacement tolerance in design is assumed to be ±0.05 µm, the displacement value is 0.04 µm or less at a minus side and the displacement value is up to near 0.08 µm at a plus side. That is, it is apparent that many optical exposure shots become unexploitable. In this way, it is apparent that in the case where the random components in the displacement components in the alignment marks are distributed non-symmetrically, some disadvantages may be caused during a practical manufacturing process of a semiconductor device due to the asymmetry in the displacement of the corrected coordinates of each of the alignment marks, irrespective of the problem concerning the specification of the alignment (for example, $|X_{ave}| + 3\sigma X$). An asymmetrical distribution of the corrected coordinates of each of the alignment marks is a phenomenon which may easily and frequently occur in the actual manufacturing process for a semiconductor device and the related art alignment method may not accomplish a satisfactory alignment accuracy in such a case.

The alignment process was carried out by the alignment method of the first embodiment of the invention on the basis of the value of the measured position data of the alignment marks of the first pattern (base pattern) before the same alignment correction as in the related art alignment method shown in the frequency distribution figure of Fig. 21. The alignment displacement tolerance values were set as follows.

$tol_X = 0.05$ µm

$tol_Y = 0.05$ µm

Accordingly, the alignment displacement values $E_{Xi1}$, $E_{Yi1}$ are set to be 0 within a range of ±0.05 µm of the values $\Delta X_{i1}$, $\Delta Y_{i1}$. In turn, in the case that they fall outside the alignment displacement tolerances $tol_X$, $tol_Y$, the displacement value exceeding the alignment displacement tolerances $tol_X$, $tol_Y$ is set to be an alignment displacement value. As is apparent from Fig. 23, it is possible to limit all the optical exposure shots to within the alignment displacement tolerances $tol_X$ and $tol_Y$ (0.05 µm). Accordingly, it becomes possible to limit substantially all the optical exposing shots within the standard values by the alignment method of the first preferred embodiment of the present invention. At this time, the best optimized alignment values were as follows.

$dx = 8.522231 \times 10^{-2}$ µm

$dy = 7.871484 \times 10^{-2}$ µm

$\theta = 5.213068 \times 10^{-8}$ rad

$\alpha = 1.141213 \times 10\text{-}7$ rad

$S_X = 3.974432 \times 10^{-8}$

$S_Y = 1.908899 \times 10^{-7}$

In this case,

$X_{ave} = -0.024254$ µm

$\sigma_X = 0.022712$ µm

$X_{min} = -0.053103$ µm

$X_{max} = 0.054518$ µm

$Y_{ave} = -0.013457$ µm

$\sigma_Y = 0.027324$ µm

$Y_{min} = -0.050058$ µm

$Y_{max} = 0.052214$ µm

It is apparent from these values that the related art alignment accuracy judging standards of $|X_{ave}| + 3\sigma_X$, $|Y_{ave}| + 3\sigma_Y$ are deteriorated irrespective of the fact that the alignment is most rationally attained in view of the design of a semiconductor device. The comparison is as follows :

Prior art alignment : $|X_{ave}| + 3\sigma_X = 0.06888$ µm

Alignment of the present invention: $|X_{ave}| + 3\sigma_X = 0.09239$ µm

As described above, it can be understood from the practical example of the present invention that the related art alignment method and the judgment standard do not necessarily provide the best optimized condition required in view

of the design of the semiconductor device. In turn, application of the alignment method of the present invention enables a more rational and highly accurate alignment which cannot be attained in the related art method to be obtained.

A second experimental example of the present invention will now be described.

In the second example, a displacement between the positional coordinates ($X_{Mi}$, $Y_{Mi}$) of the measured data of the alignment marks of the first pattern (base pattern) before alignment correction and the coordinates ($X_{Li}$, $Y_{Li}$) of the rational grid point corresponding to each of the alignment marks has a distribution approximating a relatively normal distribution.

Fig. 24 shows a frequency distribution curve of a displacement of the corrected coordinates ($X_{TiF}$, $Y_{TiF}$) of each of the alignment marks corresponding to the above case, from the coordinates ($X_{Li}$, $Y_{Li}$) of the rational grid point corresponding to each of the alignment marks when the alignment correction is carried out with the related art alignment method. In this case, the alignment correction coefficients are optimized by a method of least squares in such a way that the residual sum of squares may become minimum. It is apparent from Fig. 24 that the frequency distribution after correction is distributed in an approximately symmetrical arrangement around the alignment displacement 0.

With regard to the similar alignment measured data, Fig. 25 shows a frequency distribution curve of the displacement (residual) of the corrected coordinates ($X_{TiF}$, $Y_{TiF}$) of each of the alignment marks from the coordinates ($X_{Li}$, $Y_{Li}$) of the rational grid point corresponding to each of the alignment marks when the alignment correction is carried out with the alignment method of the first embodiment of the present invention. The alignment displacement tolerance values were set to have $tol_X$ = 0.05 μm and $tol_Y$ = 0.05 μm. Although slightly different from these values, the rational alignment correction result similar to that of the alignment method using the related art method of least squares could be attained in such a way that it might be easily understood.

In accordance with the present invention, it is possible to perform a more accurate alignment which could not be accomplished with the related art alignment method. As a result, it is possible to improve yield in a manufacturing step of a VLSI with an ultra fine pattern of 0.35 μm or less, obtain a high density and a fine formation of a structure of a semiconductor device under an effective distribution of the alignment displacement tolerance value. The alignment method of the present invention can always provide the most rational high accurate alignment in view of a manufacturing of a semiconductor device without adding any modification to an actual operation in the related art alignment method and without being dependent upon a tendency of the random component of the positional measured values in alignment.

## Claims

1. An alignment method for determining a position where a second pattern in respect to a first pattern is to be formed on the basis of measurement of positions of alignment marks (of the number N) associated with the first pattern formed on a substrate, comprising the steps of:

   (a) measuring the positions of the N alignment marks associated with the first pattern and calculating the coordinates of each of the alignment marks with reference to a result of such measurement;

   (b) calculating each of the errors in the X and Y directions of the alignment marks, errors in rotational directions of the alignment marks, errors of an orthogonal degree of alignment marks, and errors of magnification in the X and Y directions of the alignment marks;

   (c) calculating an initial value for getting an alignment correction coefficient under application of a method of least squares with reference to the coordinates of each of the alignment marks and the coordinates of the rational grid corresponding to each of said alignment marks on the basis of each of said errors; and

   (d) calculating correction coordinates of the alignment marks under application of said initial values; characterized in that it comprises the further steps of:

   (e) calculating a difference between each of the alignment coordinates and said corrected coordinates, setting a residual to 0 when the alignment is within a reference region and calculating a residual with said difference from the alignment tolerance value other than 0;

   (f) calculating a sum of squares from said residual; and

   (g) calculating corrected coordinates with a value of said sum of squares being within a reference value.

2. An alignment method according to claim 1 in which the correction coefficients of said corrected coordinates are

calculated by repeating said steps (e) to (g) a plurality of times.

3. An alignment method according to claim 1 in which the correction coefficients of said corrected coordinates are calculated under application of random number elements.

4. An alignment method according to claim 1 in which said residuals are calculated with reference to the shape of an actual lower layer pattern.

5. An alignment method according to Claim 4 in which the residuals are calculated with said actual lower layer pattern having a substantial circular shape.

6. An alignment method for determining a position where a second pattern in respect to a first pattern is to be formed on the basis of measurement of positions of N alignment marks associated with the first pattern formed on a substrate comprising the steps of:

(a) measuring the positions of the alignment marks of the number of N associated with the first pattern and calculating the coordinates ($X_{Mi}$, $Y_{Mi}$) (where, i = 0, 1, 2, ... N-1) of each of the alignment marks with reference to a result of such measurement;

(b) under an assumption that offsets of errors in the X and Y directions of the alignment marks are defined as dx, dy, a rotation angle of an error in a rotating direction of the alignment marks is defined as $\theta$, an orthogonal degree of layout which is an error of orthogonal degree of layout in each of the alignment marks is defined as $\alpha$, and scalings, which are variation in magnification of the alignment marks in their X and Y directions are defined as $S_X$, $S_Y$, calculating initial values dx, dy, $\theta$, $\alpha$, $S_X$, $S_Y$ for obtaining the alignment correction coefficients by a method of least squares with reference to the equations (1) and (2) below on the basis of the coordinates ($X_{Mi}$, $Y_{Mi}$) of each of the alignment marks and the coordinates ($X_{Li}$, $Y_{Li}$) of the rational grid point corresponding to each of the alignment marks:

$$\begin{pmatrix} \sum_{i=0}^{N-1} X_{Li}^2 & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^2 & \sum_{i=0}^{N-1} Y_{Li} \\ \sum_{i=0}^{N-1} X_{Li} & \sum_{i=0}^{N-1} Y_{Li} & \sum_{i=0}^{N-1} 1 \end{pmatrix} \begin{pmatrix} a \\ b \\ c \end{pmatrix} = \begin{pmatrix} \sum_{i=0}^{N-1} X_{Mi}X_{Li} \\ \sum_{i=0}^{N-1} X_{Mi}Y_{Li} \\ \sum_{i=0}^{N-1} X_{Mi} \end{pmatrix}$$

Equation (1)

$$\begin{pmatrix} \sum_{i=0}^{N-1} X_{Li}^2 & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^2 & \sum_{i=0}^{N-1} Y_{Li} \\ \sum_{i=0}^{N-1} X_{Li} & \sum_{i=0}^{N-1} Y_{Li} & \sum_{i=0}^{N-1} i \end{pmatrix} \begin{pmatrix} d \\ e \\ f \end{pmatrix} = \begin{pmatrix} \sum_{i=0}^{N-1} Y_{Mi}X_{Li} \\ \sum_{i=0}^{N-1} Y_{Mi}Y_{Li} \\ \sum_{i=0}^{N-1} Y_{Mi} \end{pmatrix}$$

$a = 1 + S_X$
$b = \alpha + \theta$
$c = d\,x$
$d = -\theta$
$e = 1 + S_Y$
$f = d\,y$

Equation (2)

(c) calculating the corrected coordinates ($X_{Ti1}$, $Y_{Ti1}$) of the alignment mark under application of said initial values;

$$\begin{pmatrix} X_{Ti1} \\ Y_{Ti1} \end{pmatrix} = \begin{pmatrix} 1+S_x & \alpha \quad \theta \\ -\theta & 1+S_y \end{pmatrix} \begin{pmatrix} X_{Li} \\ Y_{Li} \end{pmatrix} + \begin{pmatrix} dx \\ dy \end{pmatrix}$$

Equation (3)

(d) calculating difference values

$$\Delta X_{i1} = X_{Mi} - X_{Ti1}$$

$$\Delta Y_{i1} = Y_{Mi} - Y_{Ti1}$$

and determining the residuals $E_{Xi1}$, $E_{Yi1}$ in each of the alignment marks in accordance of each of the set alignment displacement tolerance values $tol_X$, $tol_Y$ in the X and Y directions which are alignment displacement values allowable in design of the device, and on the basis of the following rules :

(A) In the case where $|\Delta X_{i1}| \leqq tol_X$ and $|\Delta Y_{i1}| \leqq tol_Y$

$$E_{Xi1} = 0$$

$$E_{Yi1} = 0$$

(B) In the case where $|\Delta X_{i1}| > tol_X$ and $|\Delta Y_{i1}| > tol_Y$ :

$$E_{Xi1} = |\Delta X_{i1}| - tol_X$$

$$E_{Yi1} = |\Delta_{Yi1}| - tol_Y$$

(C) In the case where $|\Delta X_{i1}| \leqq tol_X$ and $|\Delta_{Yi1}| > tol_Y$ :

$$E_{Xi1} = 0$$

$$E_{Yi1} = |\Delta_{Yi1}| - tol_Y$$

(D) In the case where $|\Delta X_{i1}| > tol_X$ and $|\Delta Y_{i1}| \leqq tol_Y$ :

$$E_{Xi1} = |\Delta X_{i1}| - tol_X$$

$$E_{Yi1} = 0$$

(e) calculating a residual sum of squares $R_1$ on the basis of these residuals $E_{Xi1}$ and $E_{Yi1}$ using equation (4) below

$$R_1 = \sum_{i=0}^{N-1} E_{Xi1}^2 + \sum_{i=0}^{N-1} E_{Yi1}^2$$

Equation (4),

and

(f) calculating the correction coordinate with said residual sum of squares being within a reference value.

**7.** An alignment method according to claim 6 in which a reference value of said residual sum of squares is either a minimum value or a local minimum value.

**8.** An alignment method according to claim 6 in which said residuals are calculated with reference to the shape of the actual lower layer pattern.

**9.** An alignment method according to claim 8 in which residuals are calculated with said lower layer pattern having a substantial circular shape.

**10.** An alignment method for determining a position of a second pattern which is to be formed with respect to a first pattern on the basis of measurement of positions of a number N of alignment marks associated with the first pattern formed on a substrate comprising the steps of:

(a) measuring the positions of the N alignment marks associated with the first pattern and calculating the coordinates $(X_{Mi}, Y_{Mi})$ (where, i = 0, 1, 2, ... N-1) of each of the alignment marks with reference to a result of such measurement;

(b) under an assumption that offsets of errors in the X and Y directions of the alignment marks are defined as dx, dy, a rotation angle of an error in a rotating direction of the alignment marks is defined as $\theta$, an orthogonal degree of layout which is an error of orthogonal degree of layout in each of the alignment marks is defined as $\alpha$a, and scalings, which are variations in magnification of the alignment marks in their X and Y directions are defined as $S_X$, $S_Y$,

calculating initial values dx, dy, $\theta$, $\alpha$, $S_X$, $S_Y$ for obtaining the alignment correction coefficients by a method of least squares in reference to equations (1) and (2) below on the basis of the coordinates $(X_{Mi}, Y_{Mi})$ of each of the alignment marks and the coordinates $(X_{Li}, Y_{Li})$ of the rational grid point corresponding to each of the alignment marks,

$$\begin{pmatrix} \sum_{i=0}^{N-1} X_{Li}^2 & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^2 & \sum_{i=0}^{N-1} Y_{Li} \\ \sum_{i=0}^{N-1} X_{Li} & \sum_{i=0}^{N-1} Y_{Li} & \sum_{i=0}^{N-1} 1 \end{pmatrix} \begin{pmatrix} a \\ b \\ c \end{pmatrix} = \begin{pmatrix} \sum_{i=0}^{N-1} X_{Mi}X_{Li} \\ \sum_{i=0}^{N-1} X_{Mi}Y_{Li} \\ \sum_{i=0}^{N-1} X_{Mi} \end{pmatrix}$$

Equation (1)

$$\begin{pmatrix} \sum_{i=0}^{N-1} X_{Li}^2 & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^2 & \sum_{i=0}^{N-1} Y_{Li} \\ \sum_{i=0}^{N-1} X_{Li} & \sum_{i=0}^{N-1} Y_{Li} & \sum_{i=0}^{N-1} 1 \end{pmatrix} \begin{pmatrix} d \\ e \\ f \end{pmatrix} = \begin{pmatrix} \sum_{i=0}^{N-1} Y_{Mi}X_{Li} \\ \sum_{i=0}^{N-1} Y_{Mi}Y_{Li} \\ \sum_{i=0}^{N-1} Y_{Mi} \end{pmatrix}$$

$a = 1 + S_X$
$b = \alpha + \theta$
$c = dx$
$d = -\theta$
$e = 1 + S_Y$
$f = dy$

Equation (2)

(c) calculating the corrected coordinates ($X_{Ti1}$, $Y_{Ti1}$) of the alignment mark under application of said initial values:

$$\begin{pmatrix} X_{Ti1} \\ Y_{Ti1} \end{pmatrix} = \begin{pmatrix} 1+S_x & \alpha \quad \theta \\ -\theta & 1+S_y \end{pmatrix} \begin{pmatrix} X_{Li} \\ Y_{Li} \end{pmatrix} + \begin{pmatrix} dx \\ dy \end{pmatrix}$$

Equation (3)

(d) calculating difference values

$$\Delta X_{i1} = X_{Mi} - X_{Ti1}$$

$$\Delta Y_{i1} = Y_{Mi} - Y_{Ti1}$$

and determining the residuals $E_{Xi1}$, $E_{Yi1}$ in each of the alignment marks on the basis of each of the set alignment displacement tolerance values $tol_X$, $tol_Y$ in the X and Y directions which are alignment displacement values allowable in design of the device in accordance with the following rule :

(A) In the case where $|\Delta X_{i1}| \leqq tol_X$ and $|\Delta Y_{i1}| \leqq tol_Y$

$$E_{Xi1} = 0$$

$$E_{Yi1} = 0$$

(B) In the case where $|\Delta X_{i1}| > tol_X$ and $|\Delta Y_{i1}| > tol_Y$ :

$$E_{Xi1} = |\Delta X_{i1}| - tol_X$$

$$E_{Yi1} = |\Delta Y_{i1}| - tol_Y$$

(C) In the case where $|\Delta X_{i1}| \leqq tol_X$ and $|\Delta Y_{i1}| > tol_Y$ :

$$E_{Xi1} = 0$$

$$E_{Yi1} = |\Delta Y_{i1}| - tol_Y$$

(D) In the case where $|\Delta X_{i1}| > tol_X$ and $|\Delta Y_{i1}| \leqq tol_Y$ :

$$E_{Xi1} = |\Delta Xi1| - tol_X$$

$$E_{Yi1} = 0$$

calculating a residual sum of squares $R_1$ in reference to the following equation (4) on the basis of these residuals $E_{Xi1}$ and $E_{Yi1}$

$$R_1 = \sum_{i=0}^{N-1} E_{Xi1}^2 + \sum_{i=0}^{N-1} E_{Yi1}^2$$

Equation (4),

and

(e) repeating step (c) a plurality of times with the alignment correction coefficients dx, dy, $\theta$, $\alpha$ $S_X$, $S_Y$ added by random number elements $\Delta dx$, $\Delta dy$, $\Delta\theta$, $\Delta\alpha$, $\Delta S_X$, $\Delta S_Y$ being applied as new alignment correction coefficients dx, dy, $\theta$, $\alpha$, $S_X$, $S_Y$; and

(f) calculating the corrected coordinates ($X_{TiF}$, $Y_{TiF}$) of each of the alignment marks associated with the first pattern for optically exposing the second pattern with reference to the alignment correction coefficients dx, dy, $\theta$, $\alpha$, $S_X$, $S_Y$ and each of the random number elements $\Delta dx$, $\Delta dy$, $\Delta\theta$, $\Delta\alpha$, $\Delta S_X$, $S_Y$ when the minimum residual sum $R_1$ of squares is attained, using the following equation (5):

$$\begin{pmatrix} X_{TiF} \\ Y_{TiF} \end{pmatrix} = \begin{pmatrix} 1+S_x+\Delta S_x & \alpha+\Delta\alpha+\theta+\Delta\theta \\ -(\theta+\Delta\theta) & 1+S_y+\Delta S_y \end{pmatrix} \begin{pmatrix} X_{Li} \\ Y_{Li} \end{pmatrix} + \begin{pmatrix} dx+\Delta dx \\ dy+\Delta dy \end{pmatrix}$$

Equation (5)

**11.** An alignment method according to claim 10, wherein the residuals $E_{Xi1}$ and $E_{Yi1}$ in each of the alignment marks in said step (d) are changed and determined in accordance with the following rule:

(A') In the case where $\Delta X_{i1}^2 + \Delta Y_{i1}^2 \leqq tol_X^2 + tol_Y^2$

$$E_{Xi1} = 0$$

$$E_{Yi1} = 0$$

(B') In the case where $\Delta X_{i1}^2 + \Delta Y_{i1}^2 > tol_X^2 + tol_Y^2$

$$E_{Xi1}^{2} + E_{Yi1}^{2} = \Delta X_{i1}^{2} + \Delta Y_{i1}^{2} - (tol_X^{2} + tol_Y^{2})$$

**12.** An alignment method for determining a position where a third pattern with respect to a first pattern and a second pattern is to be formed on the basis of measurement of positions of a number N of alignment marks associated with the first pattern formed on a substrate, comprising the steps of:

(a) measuring the positions of the N alignment marks associated with the first pattern and calculating the coordinates of each of the alignment marks with reference to a result of such measurement;

(b) measuring positions of the N alignment marks associated with the second pattern and calculating the coordinates of each of the alignment marks with reference to a result of such measurement;

(c) calculating the amount of alignment displacement in each of the alignment marks;

(d) calculating an initial value for obtaining an alignment correction coefficient under application of a method of least squares with reference to errors in the X and Y directions of the alignment marks associated with the first pattern, errors in rotational directions of the alignment marks associated with the first pattern, errors of an orthogonal degree of alignment marks associated with the first pattern, errors of magnification in the X and Y directions of the alignment marks associated with the first pattern, the coordinates of each of the alignment marks associated with the first pattern, and the coordinates of the rational grid corresponding to each of said alignment marks;

(e) calculating the corrected coordinates under application of said correction coefficients;

(f) calculating a difference between said corrected coordinates and said alignment mark coordinates;

(g) calculating the second alignment tolerance values in the directions X and Y in reference to the first alignment displacement tolerance value and the amount of alignment displacement in each of the X and Y directions calculated at said step (f);

(h) setting the residual of each of the alignment marks associated with said first pattern 0 when it is within said second tolerance value and making a sum of squares and making a sum of squares of residuals other than said second tolerance value on the basis of the second tolerance value calculated at said step (f); and

(i) calculating the alignment correction coordinates in which said value of sum of squares is within a reference value.

**13.** An alignment method according to claim 12 in which a reference value of said sum of squares is either a minimum value or a local minimum value.

**14.** An alignment method according to claim 12 in which each of the alignment mark residuals associated with said first pattern of said step (h) is calculated in response to the shape of the actual lower layer pattern.

**15.** An alignment method according to claim 14 in which a residual is calculated with a shape of said actual lower layer pattern having a substantially circular shape.

**16.** An alignment method for determining a position where a third pattern in respect to a first pattern and a second pattern is to be formed on the basis of measurement of positions of N alignment marks associated with the first pattern formed on a substrate comprising the steps of:

(a) measuring the positions of the N alignment marks associated with the first pattern and calculating the coordinates ($X_{Mi}$, $Y_{Mi}$) (where, i = 0, 1, 2, ..., N-1) of each of the alignment marks in reference to a result of such measurement;

(b) measuring positions of the N alignment marks associated with the second pattern and obtaining the coordinates ($X_{Mi2}$, $Y_{Mi2}$) of each of the alignment marks in reference to a result of such measurement;

(c) calculating alignment displacement amounts $\Delta e_{Xi}$, $\Delta e_{Yi}$ at each of the alignment marks with reference to the following equations (6-1) and (6-2)

$$\Delta e_{Xi} = X_{Mi2} - X_{Mi} \qquad \text{Equation (6-1)}$$

$$\Delta e_{Yi} = Y_{Mi2} - Y_{Mi} \qquad \text{Equation (6-2)}$$

(d) under an assumption that offsets of errors in the directions X and Y of the alignment marks associated with the first pattern are defined as dx, dy, a rotation angle of an error in a rotating direction of the alignment marks associated with the first pattern is defined as $\theta$, an orthogonal degree of layout which is an error of orthogonal degree of layout in each of the alignment marks associated with the first pattern is defined as $\alpha$, and scalings which are variation in magnification of the alignment marks in their X and Y directions associated with the first pattern are defined as $S_X$, $S_Y$, calculating the alignment correction coefficients dx, dy, $\theta$, $\alpha$, $S_X$, $S_Y$ by a method of least squares on the basis of the coordinates ($X_{Mi}$, $Y_{Mi}$) of each of the alignment marks and the coordinates ($X_{Li}$, $Y_{Li}$) of the rational grid point corresponding to each of said alignment marks, with reference to equations (1) and (2) below

$$\begin{pmatrix} \sum_{i=0}^{N-1} X_{Li}^2 & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^2 & \sum_{i=0}^{N-1} Y_{Li} \\ \sum_{i=0}^{N-1} X_{Li} & \sum_{i=0}^{N-1} Y_{Li} & \sum_{i=0}^{N-1} i \end{pmatrix} \begin{pmatrix} a \\ b \\ c \end{pmatrix} = \begin{pmatrix} \sum_{i=0}^{N-1} X_{Mi}X_{Li} \\ \sum_{i=0}^{N-1} X_{Mi}Y_{Li} \\ \sum_{i=0}^{N-1} X_{Mi} \end{pmatrix} \qquad \text{Equation (1)}$$

$$\begin{pmatrix} \sum_{i=0}^{N-1} X_{Li}^2 & \sum_{i=0}^{N-1} X_{Li}Y_{Li} & \sum_{i=0}^{N-1} X_{Li} \\ \sum_{i=0}^{N-1} X_{Li}Y_{Li} & \sum_{i=0}^{N-1} Y_{Li}^2 & \sum_{i=0}^{N-1} Y_{Li} \\ \sum_{i=0}^{N-1} X_{Li} & \sum_{i=0}^{N-1} Y_{Li} & \sum_{i=0}^{N-1} i \end{pmatrix} \begin{pmatrix} d \\ e \\ f \end{pmatrix} = \begin{pmatrix} \sum_{i=0}^{N-1} Y_{Mi}X_{Li} \\ \sum_{i=0}^{N-1} Y_{Mi}Y_{Li} \\ \sum_{i=0}^{N-1} Y_{Mi} \end{pmatrix} \qquad \text{Equation (2)}$$

where

$a = 1 + S_X$
$b = \alpha + \theta$
$c = d\,x$

d = -θ
e = 1 + $S_Y$
f = d y

(e) calculating the corrected coordinates ($X_{Ti1}$, $Y_{Ti1}$) of the alignment mark with reference to the alignment correction coefficients dx, dy, θ, α, $S_X$, $S_Y$ using the following equation (3)

$$\begin{pmatrix} X_{Ti1} \\ Y_{Ti1} \end{pmatrix} = \begin{pmatrix} 1+S_x & \alpha & \theta \\ -\theta & 1+S_y & \end{pmatrix} \begin{pmatrix} X_{Li} \\ Y_{Li} \end{pmatrix} + \begin{pmatrix} dx \\ dy \end{pmatrix}$$

Equation (3)

then, calculating difference values

$$\Delta X_{i1} = X_{Mi} - X_{Ti1}$$

$$\Delta Y_{i1} = Y_{Mi} - Y_{Ti1}$$

then, determining alignment displacement tolerance values $tol_X$ and $tol_Y$ in the X and Y directions which are alignment displacement values allowable in design of the device, alignment displacement amounts $\Delta e_{Xi}$, $\Delta e_{Yi}$ calculated at said step (f), new alignment displacement tolerances $tol_X'$ and $tol_Y'$ in the X and Y directions on the basis of said $\Delta X_{i1}$, $\Delta Y_{i1}$ in accordance with the following rules in the case where (x - 1) $\Delta e_{Xi} \geqq 0$ and $\Delta X_{i0} \geqq 0$ :

$$tol_X' = tol_X$$

in the case where (x - 2) $\Delta e_{Xi} \geqq 0$ and $\Delta X_{i0} < 0$ :

$$tol_X' = tol_X - |\Delta e_{Xi}|$$

in the case where (x - 3) $\Delta e_{Xi} < 0$ and $\Delta X_{i0} \geqq 0$ :

$$tol_X' = tol_X - |\Delta e_{Xi}|$$

in the case where (x - 4) $\Delta e_{Xi} < 0$ and $\Delta X_{i0} < 0$ :

$$tol_X' = tol_X$$

in the case where (y - 1) $\Delta e_{Yi} \geqq 0$ and $\Delta Y_{i0} \geqq 0$ :

$$tol_Y' = tol_Y$$

in the case where (y - 2) $\Delta e_{Yi} \geqq 0$ and $\Delta Y_{i0} < 0$ :

$$tol_Y' = tol_Y - |\Delta e_{Yi}|$$

in the case where (y - 3) $\Delta e_{Yi} < 0$ and $\Delta Y_{i0} \geqq 0$ :

$$tol_Y' = tol_Y - |\Delta e_{Yi}|$$

in the case where (y - 4) $\Delta e_{Yi} < 0$ and $\Delta Y_{i0} < 0$ :

$$tol_Y' = tol_Y$$

and determining the residuals $E_{Xi1}$, $E_{Yi1}$ in each of the alignment marks associated with the first pattern on the basis of each of the $tol_X'$, $tol_Y'$ in accordance with the following rule,

(A) In the case where $|\Delta X_{i1}| < tol_X'$ and $|\Delta Y_{i1}| \leqq tol_Y'$

$$E_{Xi1} = 0$$

$$E_{Yi1} = 0$$

(B) In the case that $|\Delta X_{i1}| > tol_X'$ and $|\Delta Y_{i1}| > tol_Y'$ :

$$EX_{i1} = |\Delta X_{i1}| - tol_X'$$

$$EY_{i1} = |\Delta Y_{i1}| - tol_Y'$$

(C) In the case where $|\Delta X_{i1}| \leqq tol_X'$ and $|\Delta Y_{i1}| > tol_Y'$ :

$$E_{Xi1} = 0$$

$$E_{Yi1} = |\Delta Y_{i1}| - tol_Y'$$

(D) In the case where $|\Delta X_{i1}| > tol_X'$ and $|\Delta Y_{i1}| \leqq tol_Y'$ :

$$E_{Xi1} = |\Delta X_{i1}| - tol_X'$$

$$E_{Yi1} = 0$$

then calculating a residual sum of squares $R_1$ on the basis of these residuals $E_{Xi1}$ and $E_{Yi1}$ using the following equation (4)

$$R_1 = \sum_{i=0}^{N-1} E_{Xi1}^2 + \sum_{i=0}^{N-1} E_{Yi1}^2$$

Equation (4),

and

(g) repeating step (e) for a plurality of times with the alignment correction coefficients dx, dy, θ, α, $S_X$, $S_Y$ added with the elements Δdx, Δdy, Δθ, Δα, $\Delta S_X$, $\Delta S_Y$ being applied as new alignment correction coefficients dx, dy, θ, α, $S_X$, $S_Y$; and

(h) calculating the corrected coordinates ($X_{TiF}$, $Y_{TiF}$) of the alignment mark associated with the first pattern for optically exposing the third pattern on the basis of the alignment correction coefficients dx, dy, θ, α, $S_X$, $S_Y$ and each of the elements Δdx, Δdy, Δθ, Δα, $\Delta S_X$, $\Delta S_Y$ when the minimum residual sum of squares $R_1$ is obtained using the following equation (5)

$$\begin{pmatrix} X_{TiF} \\ Y_{TiF} \end{pmatrix} = \begin{pmatrix} 1+S_x+\Delta S_x & \alpha+\Delta\alpha+\theta+\Delta\theta \\ -(\theta+\Delta\theta) & 1+S_y+\Delta S_y \end{pmatrix} \begin{pmatrix} X_{Li} \\ Y_{Li} \end{pmatrix} + \begin{pmatrix} dx+\Delta dx \\ dy+\Delta dy \end{pmatrix}$$

Equation (5)

**17.** An alignment method according to claim 3 in which the residuals $E_{Xi1}$, $E_{Yi1}$ in each of the alignment marks associated with the first pattern in said step (e) are changed and determined in accordance with the following rule,

(A') In the case where $\Delta X_{i1}^2 + \Delta Y_{i1}^2 \leqq tol_X^2 + tol_Y^2$

$$E_{Xi1} = 0$$

$$E_{Yi1} = 0$$

(B') In the case where $\Delta X_{i1}^2 + \Delta Y_{i1}^2 > tol_X^2 + tol_Y^2$

$$E_{Xi1}^2 + E_{Yi1}^2 = \Delta X_{i1}^2 + \Delta Y_{i1}^2 - (tol_X'^2 + tol_Y'^2)$$

FIG. 1

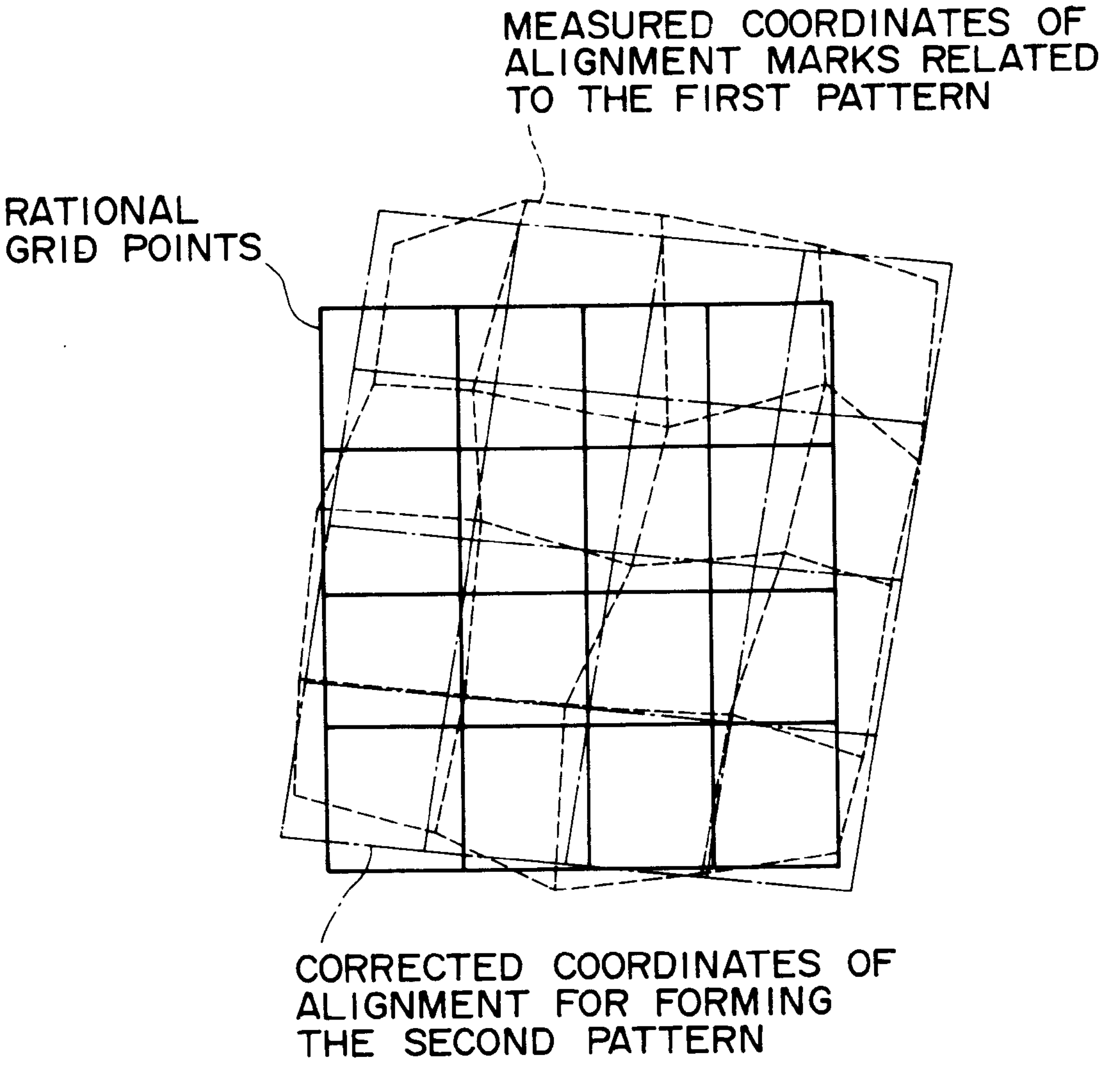
MEASURED COORDINATES OF ALIGNMENT MARKS RELATED TO THE FIRST PATTERN
RATIONAL GRID POINTS
CORRECTED COORDINATES OF ALIGNMENT FOR FORMING THE SECOND PATTERN

FIG. 2

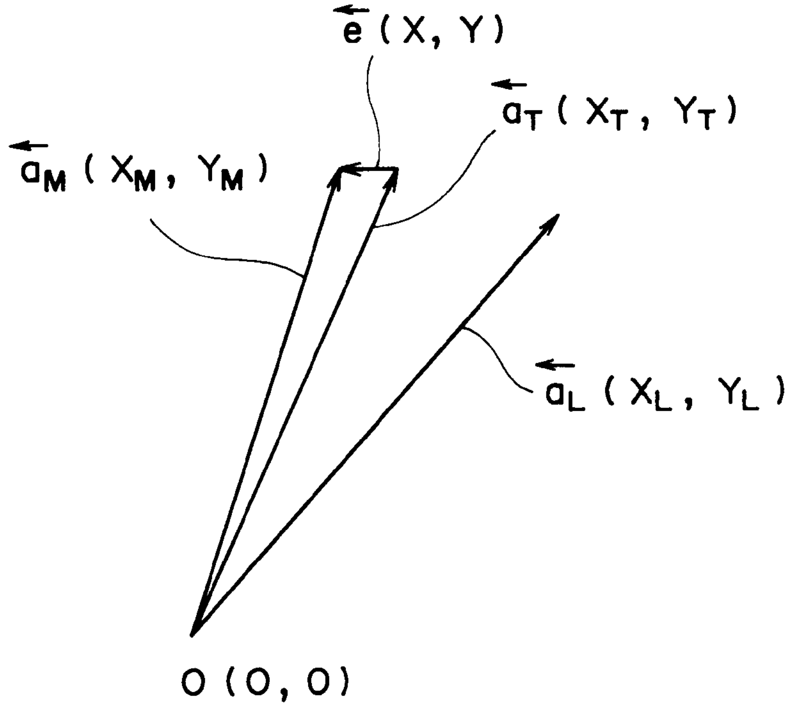

$\overleftarrow{e}$ (X, Y)
$\overleftarrow{a}_T$ ($X_T$, $Y_T$)
$\overleftarrow{a}_M$ ($X_M$, $Y_M$)
$\overleftarrow{a}_L$ ($X_L$, $Y_L$)
O (0, 0)

F I G. 3A

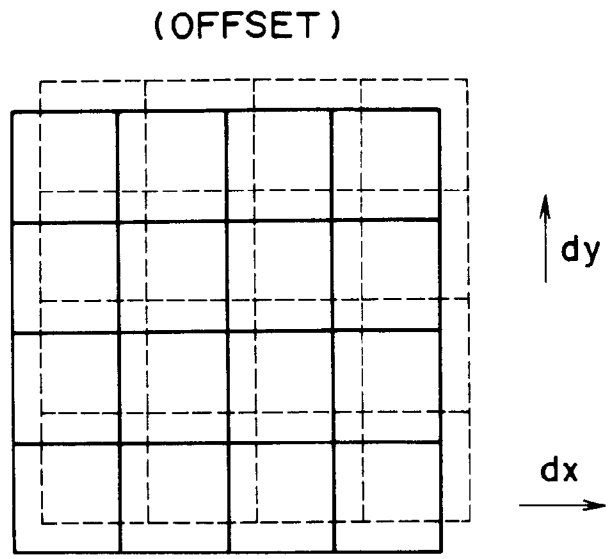


F I G. 3B

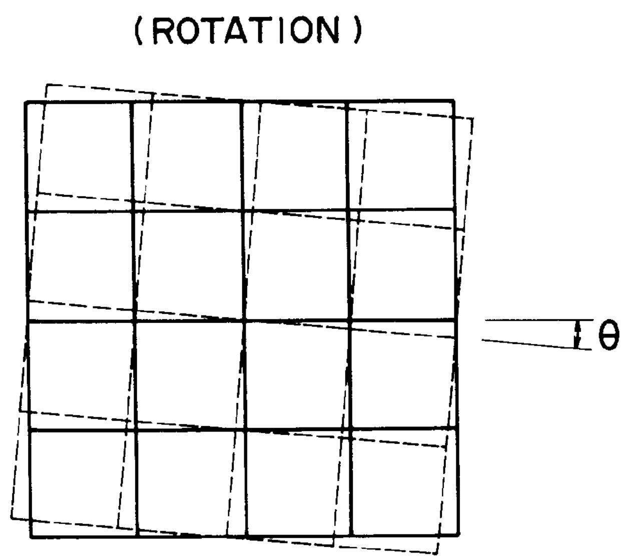

FIG. 4A

(ORTHOGONAL DEGREE OF LAYOUT)

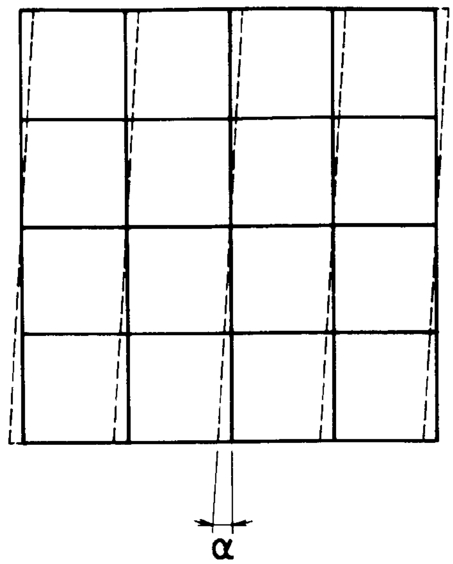


FIG. 4B

(SCALING)

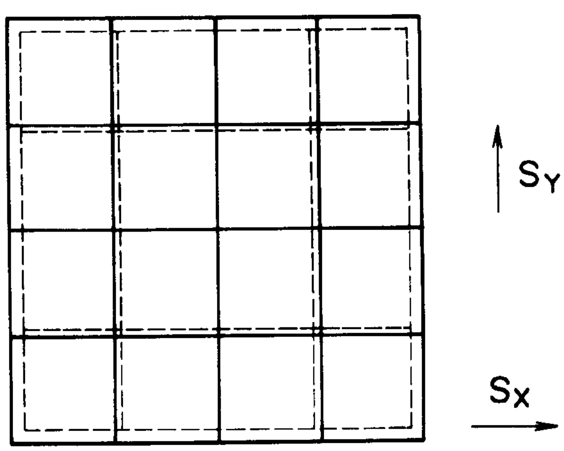

FIG. 5

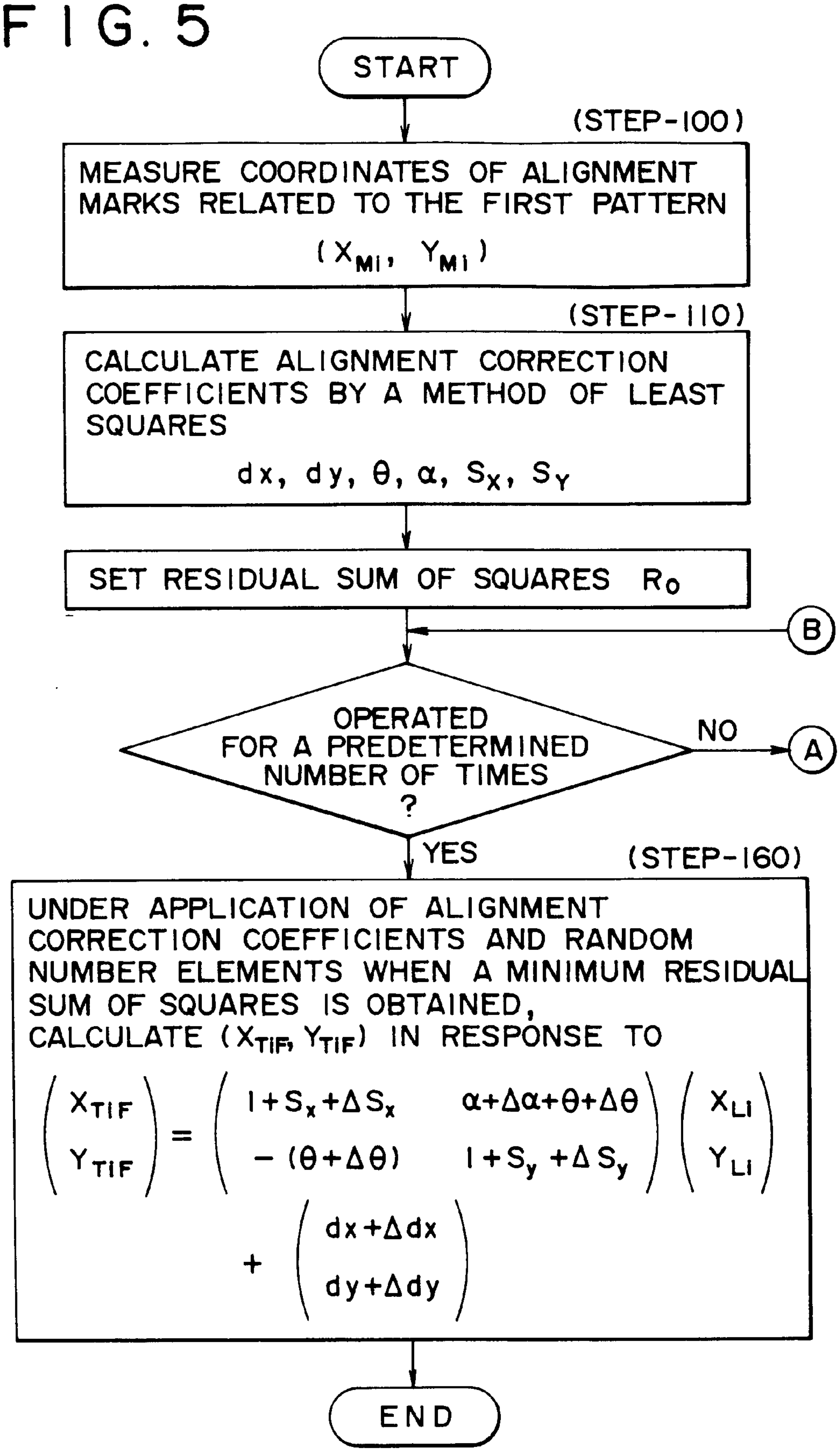
START
(STEP-100)
MEASURE COORDINATES OF ALIGNMENT MARKS RELATED TO THE FIRST PATTERN
$(X_{MI}, Y_{MI})$
(STEP-110)
CALCULATE ALIGNMENT CORRECTION COEFFICIENTS BY A METHOD OF LEAST SQUARES
$dx, dy, \theta, \alpha, S_X, S_Y$
SET RESIDUAL SUM OF SQUARES $R_0$
B
OPERATED FOR A PREDETERMINED NUMBER OF TIMES ?
NO
A
YES
(STEP-160)
UNDER APPLICATION OF ALIGNMENT CORRECTION COEFFICIENTS AND RANDOM NUMBER ELEMENTS WHEN A MINIMUM RESIDUAL SUM OF SQUARES IS OBTAINED, CALCULATE $(X_{TIF}, Y_{TIF})$ IN RESPONSE TO
$$\begin{pmatrix} X_{TIF} \\ Y_{TIF} \end{pmatrix} = \begin{pmatrix} 1+S_x+\Delta S_x & \alpha+\Delta\alpha+\theta+\Delta\theta \\ -(\theta+\Delta\theta) & 1+S_y+\Delta S_y \end{pmatrix} \begin{pmatrix} X_{LI} \\ Y_{LI} \end{pmatrix} + \begin{pmatrix} dx+\Delta dx \\ dy+\Delta dy \end{pmatrix}$$
END

FIG. 6

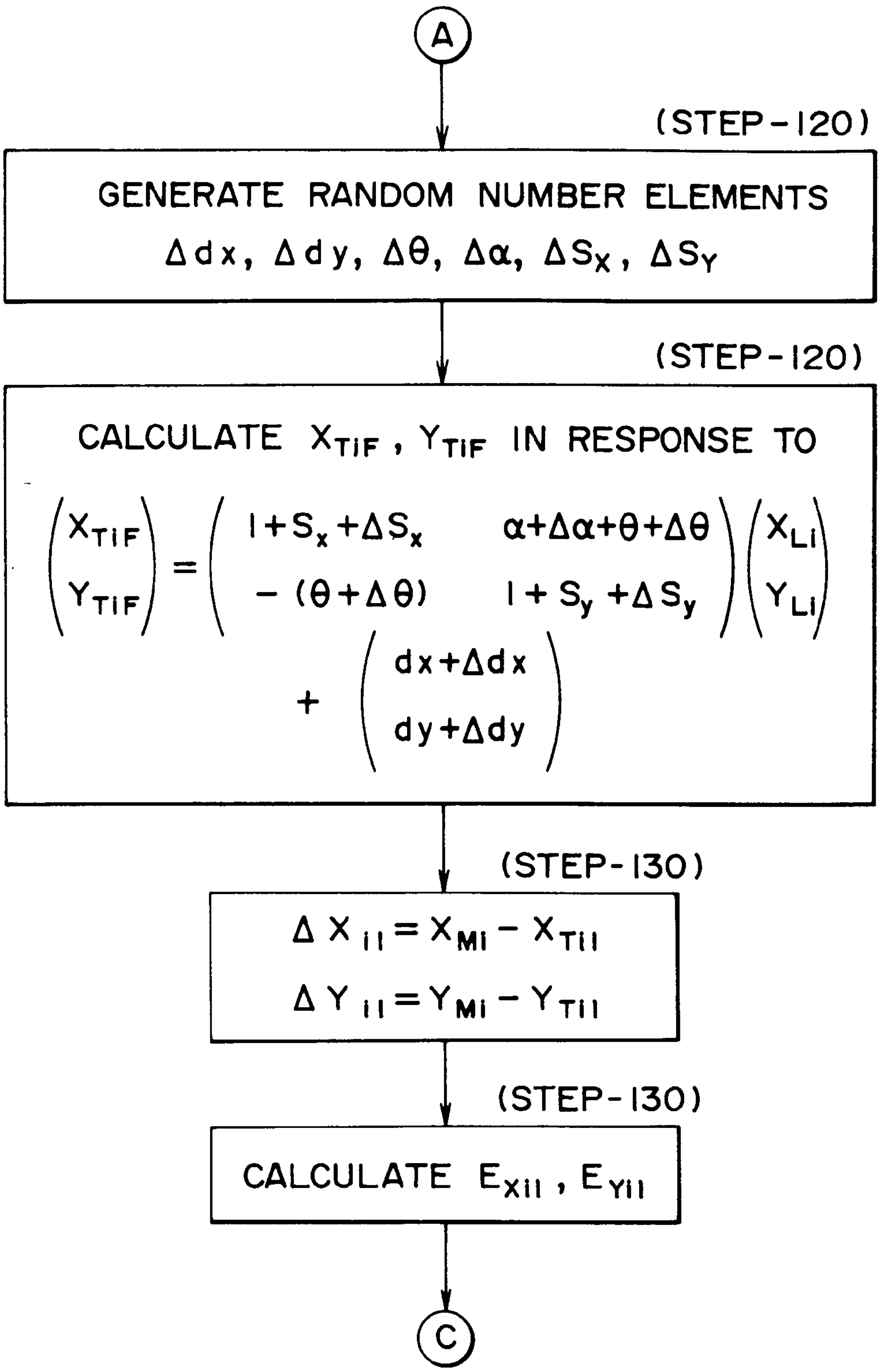
A
(STEP-120)
GENERATE RANDOM NUMBER ELEMENTS
$\Delta dx$, $\Delta dy$, $\Delta\theta$, $\Delta\alpha$, $\Delta S_X$, $\Delta S_Y$
(STEP-120)
CALCULATE $X_{TIF}$, $Y_{TIF}$ IN RESPONSE TO
$\begin{pmatrix} X_{TIF} \\ Y_{TIF} \end{pmatrix} = \begin{pmatrix} 1+S_x+\Delta S_x & \alpha+\Delta\alpha+\theta+\Delta\theta \\ -(\theta+\Delta\theta) & 1+S_y+\Delta S_y \end{pmatrix} \begin{pmatrix} X_{Li} \\ Y_{Li} \end{pmatrix} + \begin{pmatrix} dx+\Delta dx \\ dy+\Delta dy \end{pmatrix}$
(STEP-130)
$\Delta X_{i1} = X_{Mi} - X_{Ti1}$
$\Delta Y_{i1} = Y_{Mi} - Y_{Ti1}$
(STEP-130)
CALCULATE $E_{Xi1}$, $E_{Yi1}$
C

FIG. 7

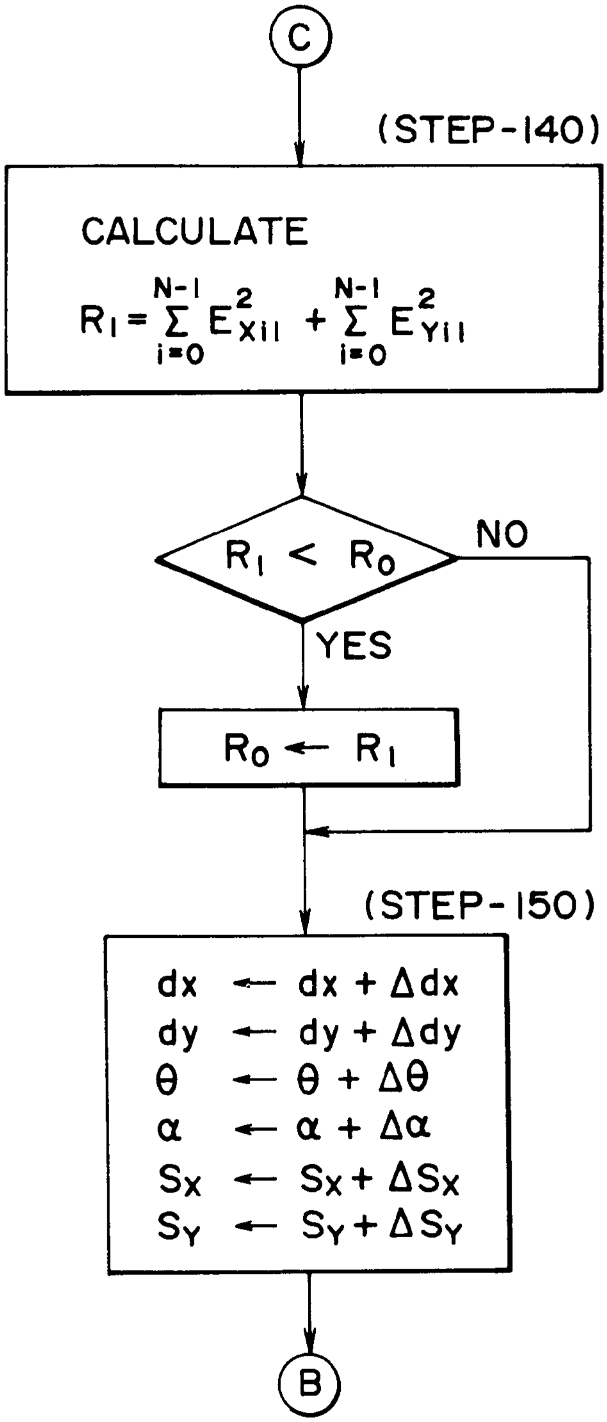
C
(STEP-140)
CALCULATE
$R_1 = \sum_{i=0}^{N-1} E_{Xi1}^2 + \sum_{i=0}^{N-1} E_{Yi1}^2$
$R_1 < R_0$
NO
YES
$R_0 \leftarrow R_1$
(STEP-150)
$dx \leftarrow dx + \Delta dx$
$dy \leftarrow dy + \Delta dy$
$\theta \leftarrow \theta + \Delta\theta$
$\alpha \leftarrow \alpha + \Delta\alpha$
$S_X \leftarrow S_X + \Delta S_X$
$S_Y \leftarrow S_Y + \Delta S_Y$
B

# FIG. 8

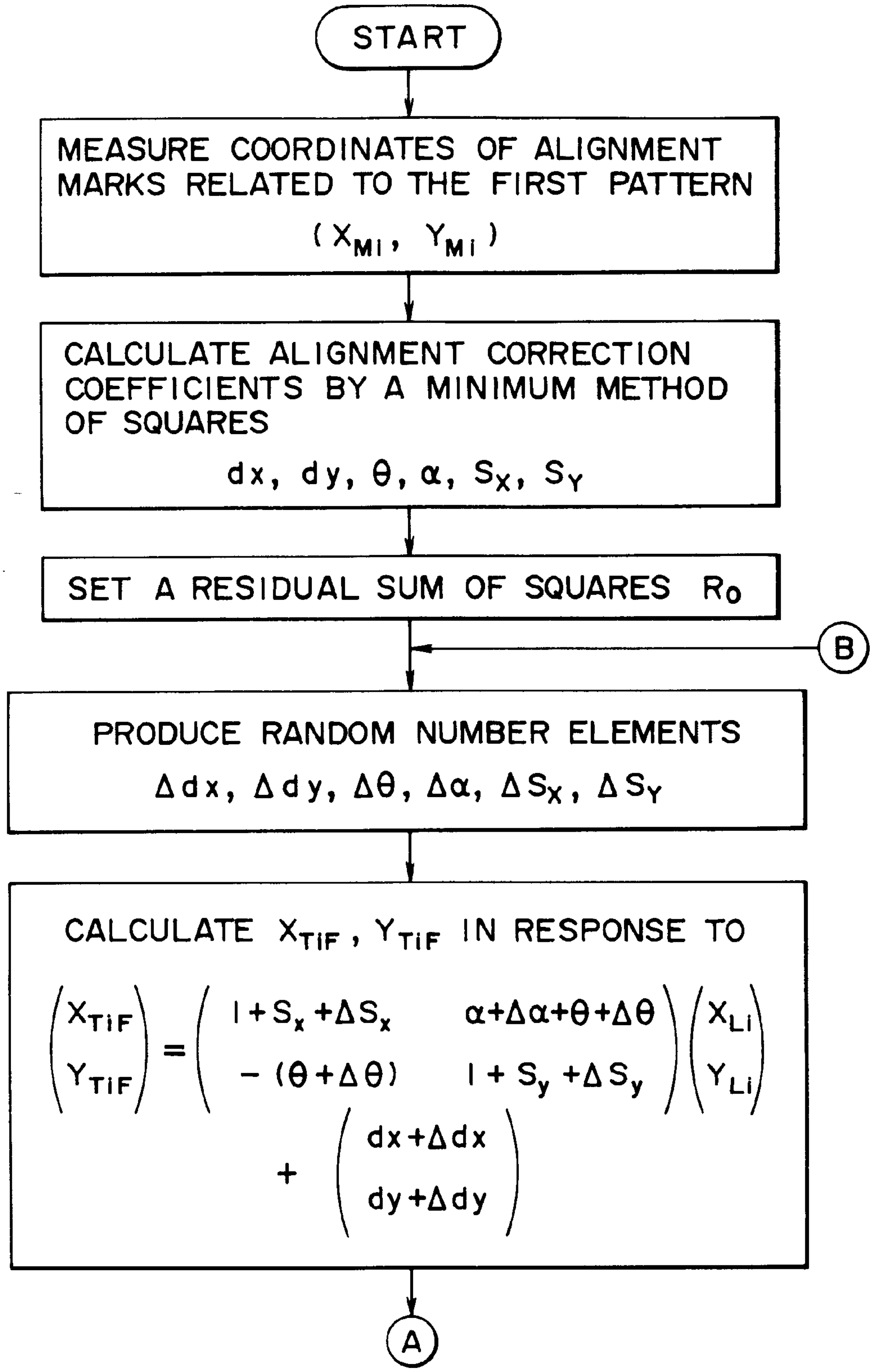
START
MEASURE COORDINATES OF ALIGNMENT MARKS RELATED TO THE FIRST PATTERN
$(X_{Mi}, Y_{Mi})$
CALCULATE ALIGNMENT CORRECTION COEFFICIENTS BY A MINIMUM METHOD OF SQUARES
$dx, dy, \theta, \alpha, S_X, S_Y$
SET A RESIDUAL SUM OF SQUARES $R_0$
B
PRODUCE RANDOM NUMBER ELEMENTS
$\Delta dx, \Delta dy, \Delta\theta, \Delta\alpha, \Delta S_X, \Delta S_Y$
CALCULATE $X_{TiF}$, $Y_{TiF}$ IN RESPONSE TO
$\begin{pmatrix} X_{TiF} \\ Y_{TiF} \end{pmatrix} = \begin{pmatrix} 1+S_x+\Delta S_x & \alpha+\Delta\alpha+\theta+\Delta\theta \\ -(\theta+\Delta\theta) & 1+S_y+\Delta S_y \end{pmatrix} \begin{pmatrix} X_{Li} \\ Y_{Li} \end{pmatrix} + \begin{pmatrix} dx+\Delta dx \\ dy+\Delta dy \end{pmatrix}$
A

FIG. 9

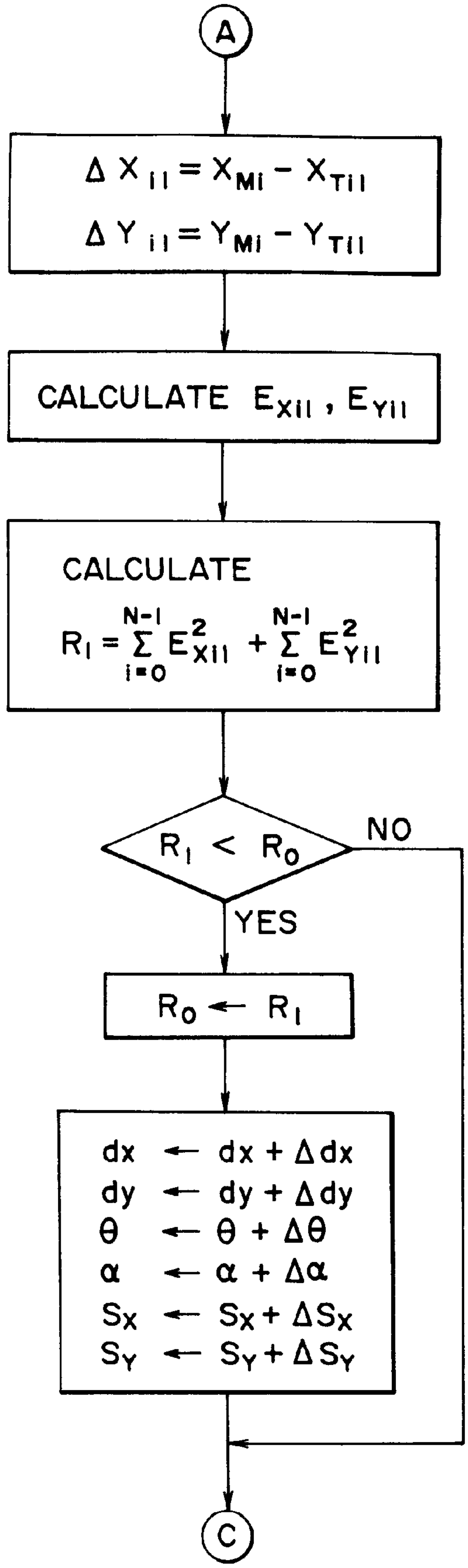
A
$\Delta X_{i1} = X_{Mi} - X_{Ti1}$
$\Delta Y_{i1} = Y_{Mi} - Y_{Ti1}$
CALCULATE $E_{Xi1}$, $E_{Yi1}$
CALCULATE
$R_1 = \sum_{i=0}^{N-1} E_{Xi1}^2 + \sum_{i=0}^{N-1} E_{Yi1}^2$
$R_1 < R_0$
NO
YES
$R_0 \leftarrow R_1$
$dx \leftarrow dx + \Delta dx$
$dy \leftarrow dy + \Delta dy$
$\theta \leftarrow \theta + \Delta\theta$
$\alpha \leftarrow \alpha + \Delta\alpha$
$S_X \leftarrow S_X + \Delta S_X$
$S_Y \leftarrow S_Y + \Delta S_Y$
C

FIG. 10

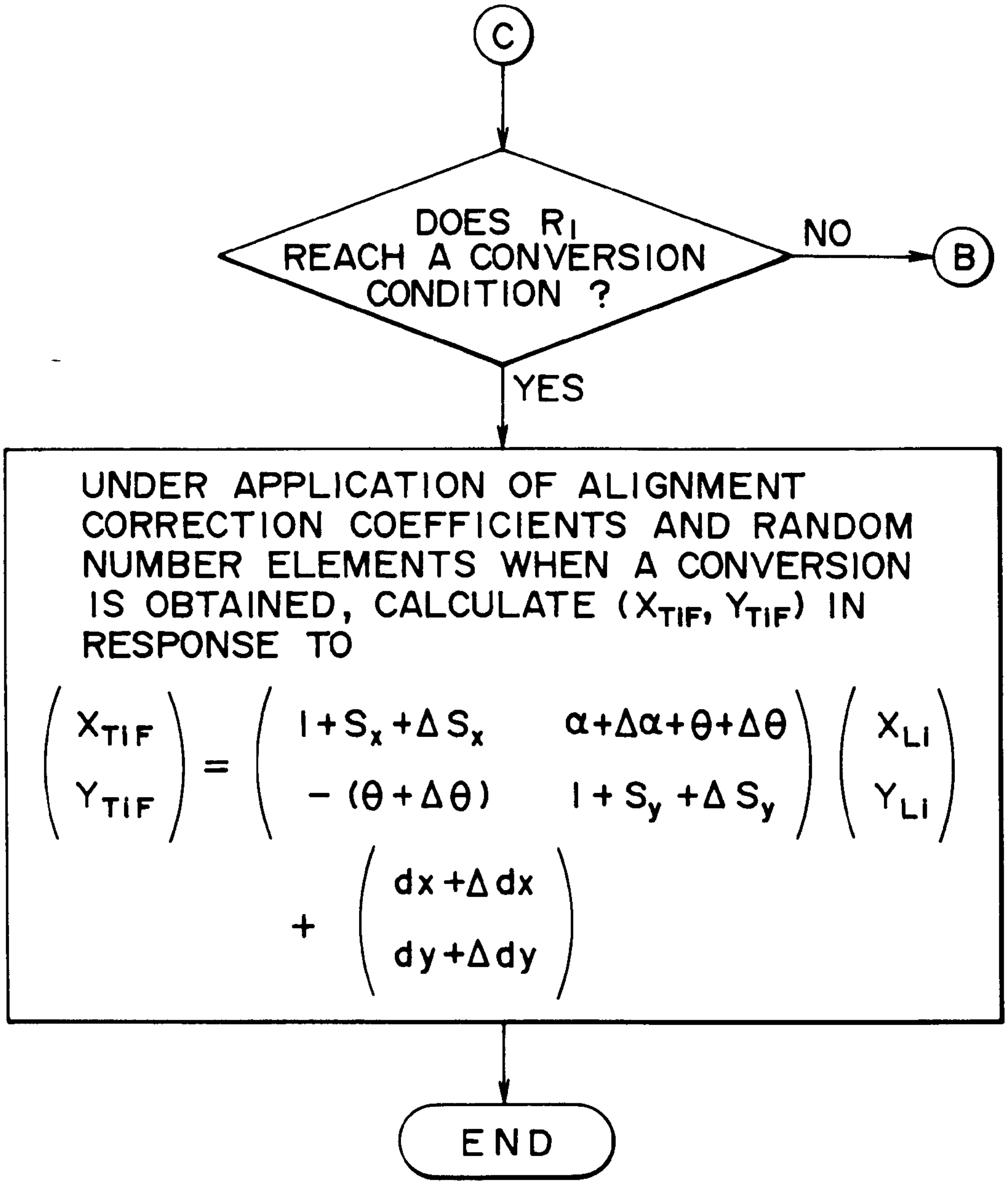
C
DOES $R_I$ REACH A CONVERSION CONDITION ?
NO
B
YES
UNDER APPLICATION OF ALIGNMENT CORRECTION COEFFICIENTS AND RANDOM NUMBER ELEMENTS WHEN A CONVERSION IS OBTAINED, CALCULATE ($X_{TIF}$, $Y_{TIF}$) IN RESPONSE TO
$$\begin{pmatrix} X_{TIF} \\ Y_{TIF} \end{pmatrix} = \begin{pmatrix} 1+S_x+\Delta S_x & \alpha+\Delta\alpha+\theta+\Delta\theta \\ -(\theta+\Delta\theta) & 1+S_y+\Delta S_y \end{pmatrix} \begin{pmatrix} X_{Li} \\ Y_{Li} \end{pmatrix} + \begin{pmatrix} dx+\Delta dx \\ dy+\Delta dy \end{pmatrix}$$
END

FIG. 11

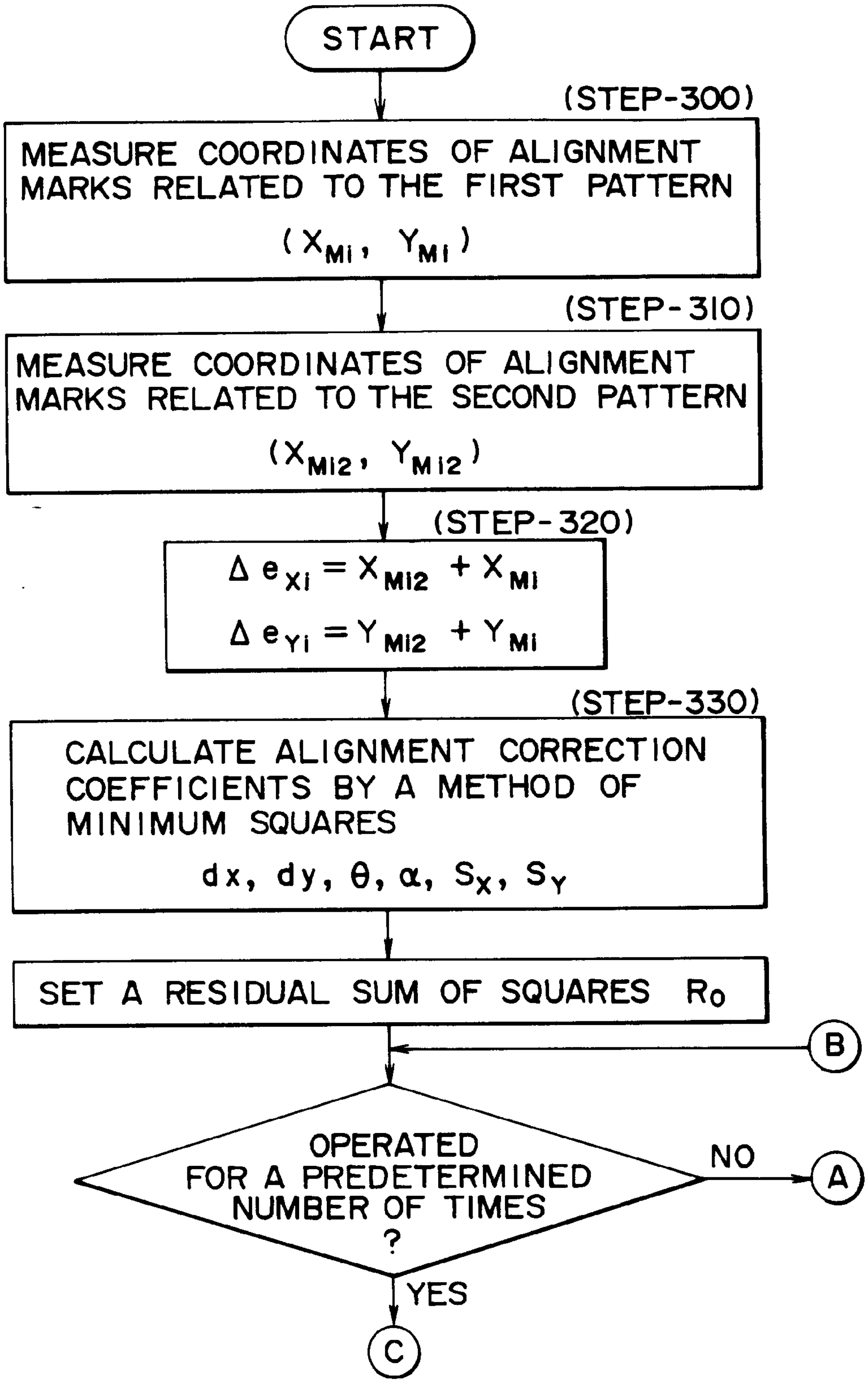
START
(STEP-300)
MEASURE COORDINATES OF ALIGNMENT MARKS RELATED TO THE FIRST PATTERN
$(X_{M1}, Y_{M1})$
(STEP-310)
MEASURE COORDINATES OF ALIGNMENT MARKS RELATED TO THE SECOND PATTERN
$(X_{M12}, Y_{M12})$
(STEP-320)
$\Delta e_{Xi} = X_{M12} + X_{M1}$
$\Delta e_{Yi} = Y_{M12} + Y_{M1}$
(STEP-330)
CALCULATE ALIGNMENT CORRECTION COEFFICIENTS BY A METHOD OF MINIMUM SQUARES
$dx, dy, \theta, \alpha, S_X, S_Y$
SET A RESIDUAL SUM OF SQUARES $R_0$
B
OPERATED FOR A PREDETERMINED NUMBER OF TIMES ?
NO
A
YES
C

FIG. 12

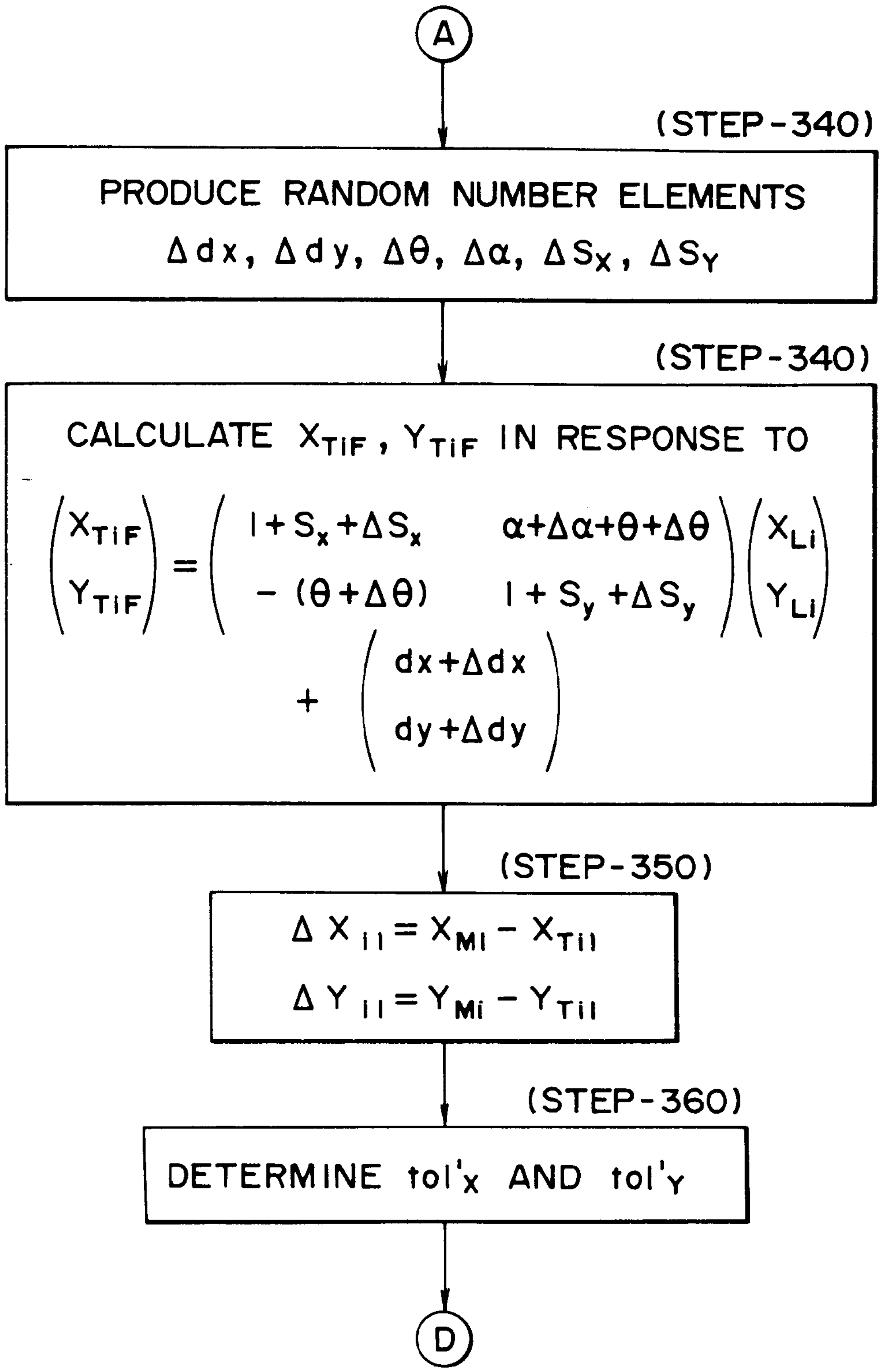
A
(STEP-340)
PRODUCE RANDOM NUMBER ELEMENTS
$\Delta dx$, $\Delta dy$, $\Delta\theta$, $\Delta\alpha$, $\Delta S_X$, $\Delta S_Y$
(STEP-340)
CALCULATE $X_{TiF}$, $Y_{TiF}$ IN RESPONSE TO
$\begin{pmatrix} X_{TiF} \\ Y_{TiF} \end{pmatrix} = \begin{pmatrix} 1+S_x+\Delta S_x & \alpha+\Delta\alpha+\theta+\Delta\theta \\ -(\theta+\Delta\theta) & 1+S_y+\Delta S_y \end{pmatrix} \begin{pmatrix} X_{Li} \\ Y_{Li} \end{pmatrix} + \begin{pmatrix} dx+\Delta dx \\ dy+\Delta dy \end{pmatrix}$
(STEP-350)
$\Delta X_{1I} = X_{MI} - X_{TiI}$
$\Delta Y_{1I} = Y_{Mi} - Y_{TiI}$
(STEP-360)
DETERMINE $tol'_X$ AND $tol'_Y$
D

F I G. 13

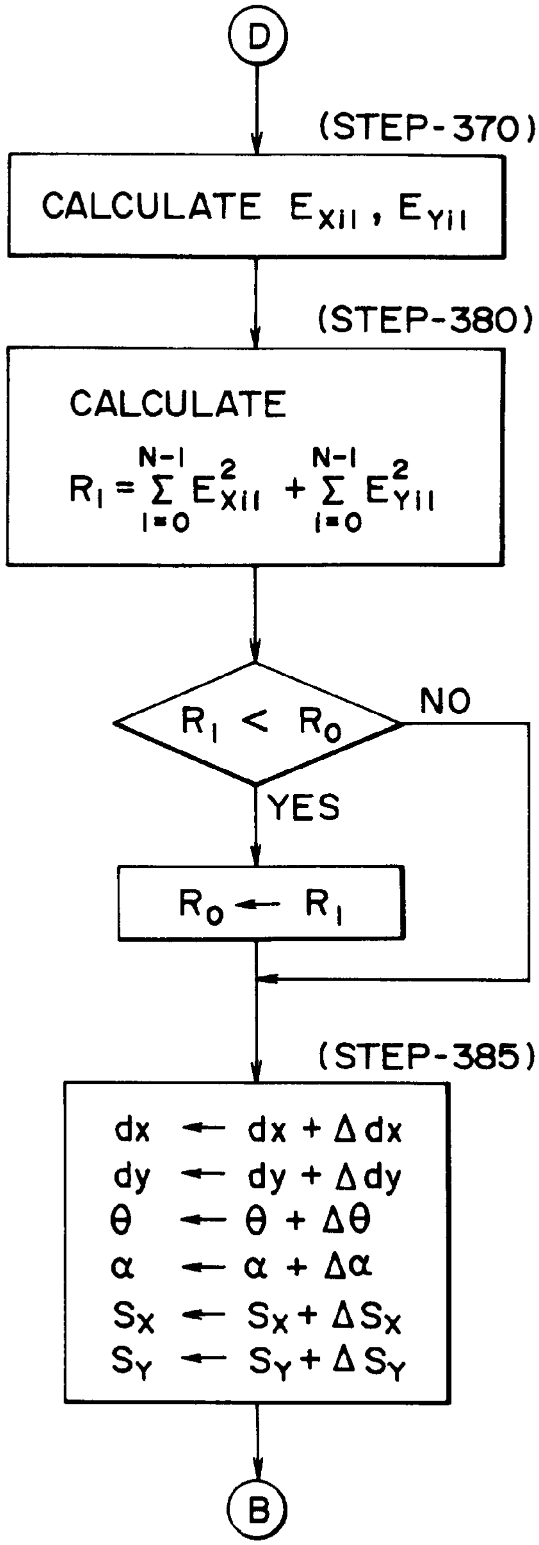
D
(STEP-370)
CALCULATE $E_{XII}$, $E_{YII}$
(STEP-380)
CALCULATE
$R_I = \sum_{I=0}^{N-1} E_{XII}^2 + \sum_{I=0}^{N-1} E_{YII}^2$
$R_I < R_0$
NO
YES
$R_0 \leftarrow R_I$
(STEP-385)
$dx \leftarrow dx + \Delta dx$
$dy \leftarrow dy + \Delta dy$
$\theta \leftarrow \theta + \Delta\theta$
$\alpha \leftarrow \alpha + \Delta\alpha$
$S_X \leftarrow S_X + \Delta S_X$
$S_Y \leftarrow S_Y + \Delta S_Y$
B

# FIG. 14

(C)

(STEP-390)

- UNDER APPLICATION OF ALIGNMENT CORRECTION COEFFICIENTS AND RANDOM NUMBER ELEMENTS WHEN A MINIMUM RESIDUAL SUM OF SQUARES IS OBTAINED, CALCULATE $(X_{TIF}, Y_{TIF})$ IN RESPONSE TO

$$\begin{pmatrix} X_{TIF} \\ Y_{TIF} \end{pmatrix} = \begin{pmatrix} 1+S_x+\Delta S_x & \alpha+\Delta\alpha+\theta+\Delta\theta \\ -(\theta+\Delta\theta) & 1+S_y+\Delta S_y \end{pmatrix} \begin{pmatrix} X_{Li} \\ Y_{Li} \end{pmatrix} + \begin{pmatrix} dx+\Delta dx \\ dy+\Delta dy \end{pmatrix}$$

END

FIG. 15A

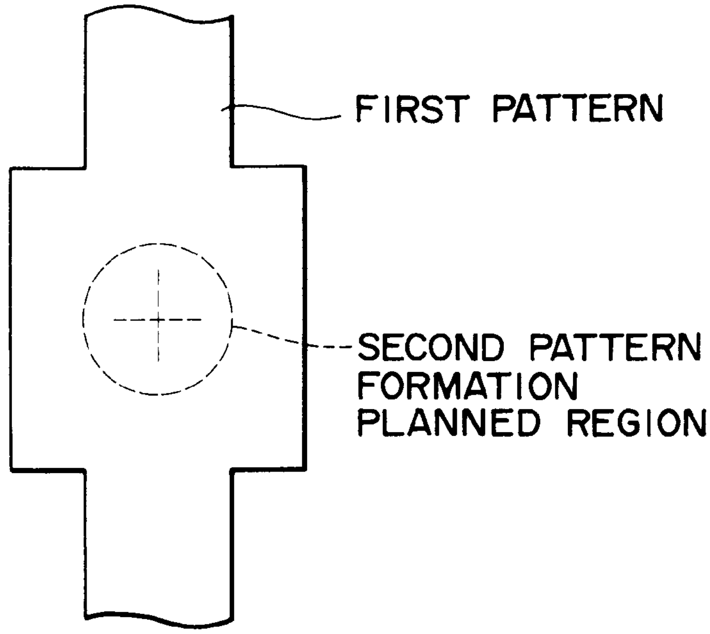


FIG. 15B

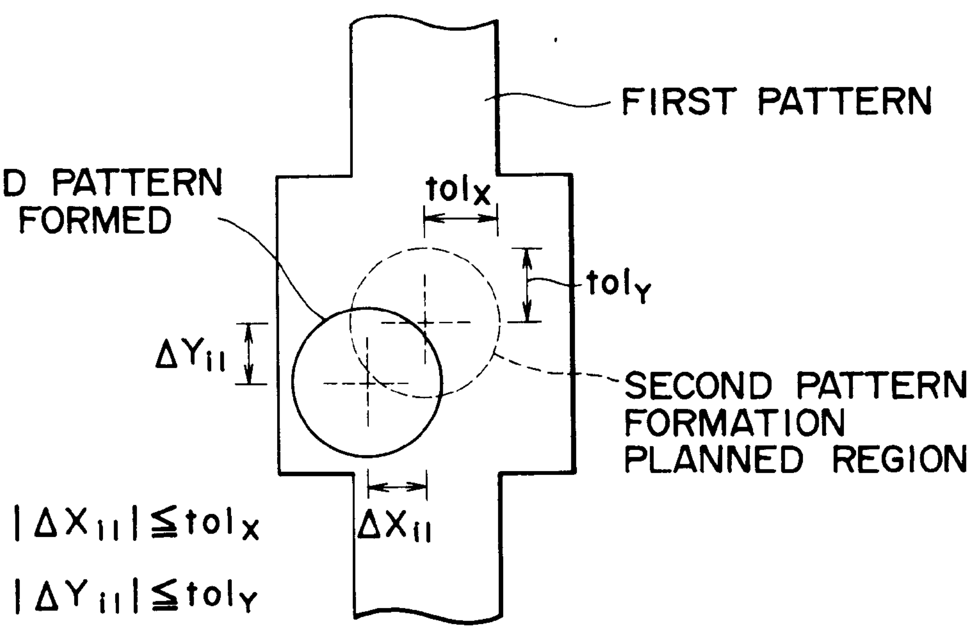


$|\Delta X_{i1}| \leqq tol_X$

$|\Delta Y_{i1}| \leqq tol_Y$

$\Delta E_{Xi1} = 0$

$\Delta E_{Yi1} = 0$

# FIG. 16A

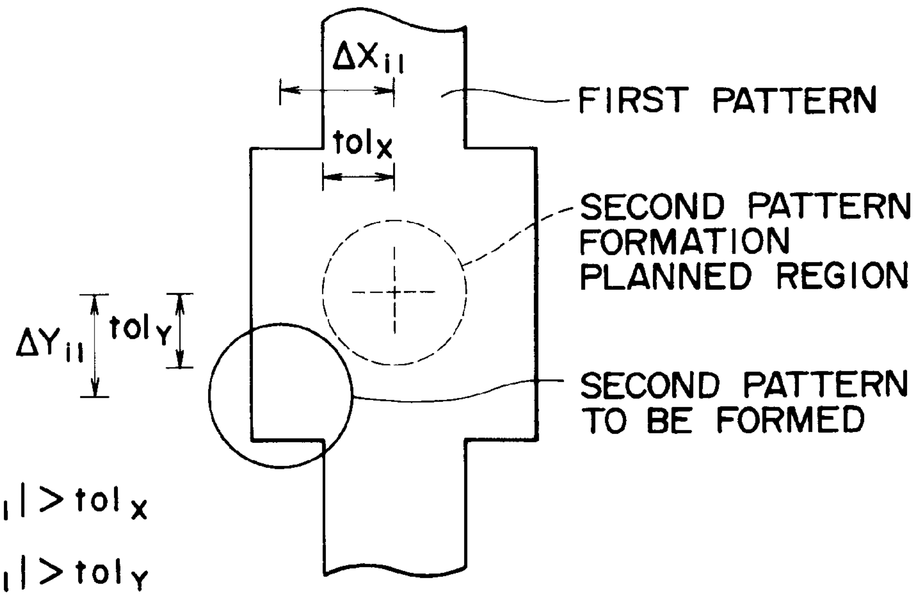


$|\Delta X_{i1}| > tol_X$

$|\Delta Y_{i1}| > tol_Y$

$\Delta E_{Xi1} = |\Delta X_{i1}| - tol_X$

$\Delta E_{Yi1} = |\Delta Y_{i1}| - tol_Y$

# FIG. 16B

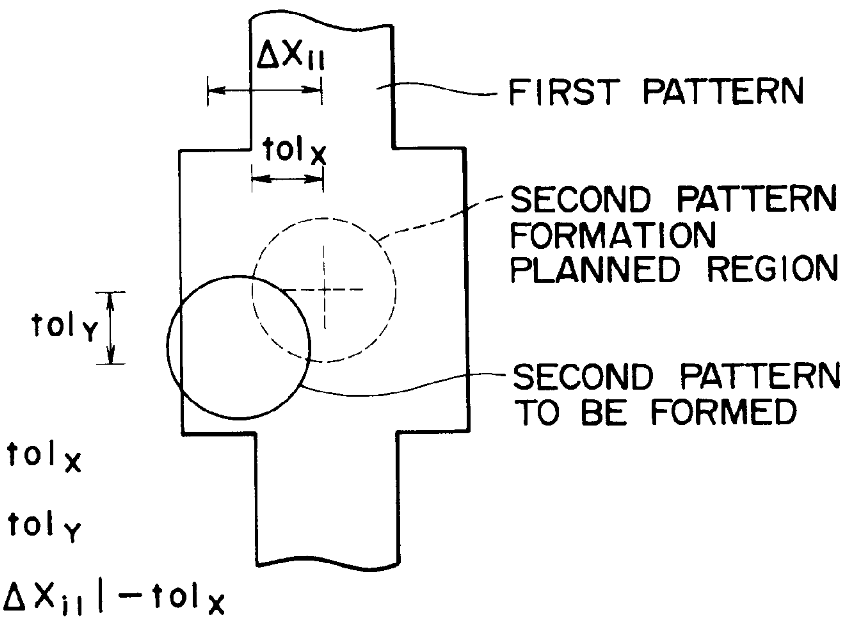


$|\Delta X_{i1}| > tol_X$

$|\Delta Y_{i1}| \leqq tol_Y$

$\Delta E_{Xi1} = |\Delta X_{i1}| - tol_X$

$\Delta E_{Yi1} = 0$

FIG. 17

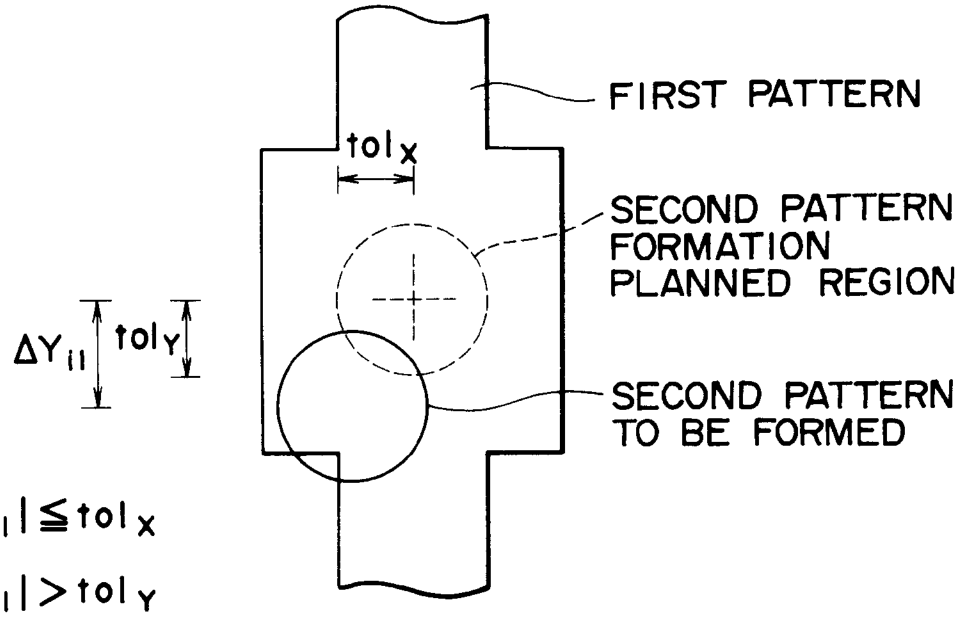


$$|\Delta X_{11}| \leqq tol_X$$

$$|\Delta Y_{11}| > tol_Y$$

$$\Delta E_{X11} = 0$$

$$\Delta E_{Y11} = |\Delta Y_{11}| - tol_Y$$

FIG. 18

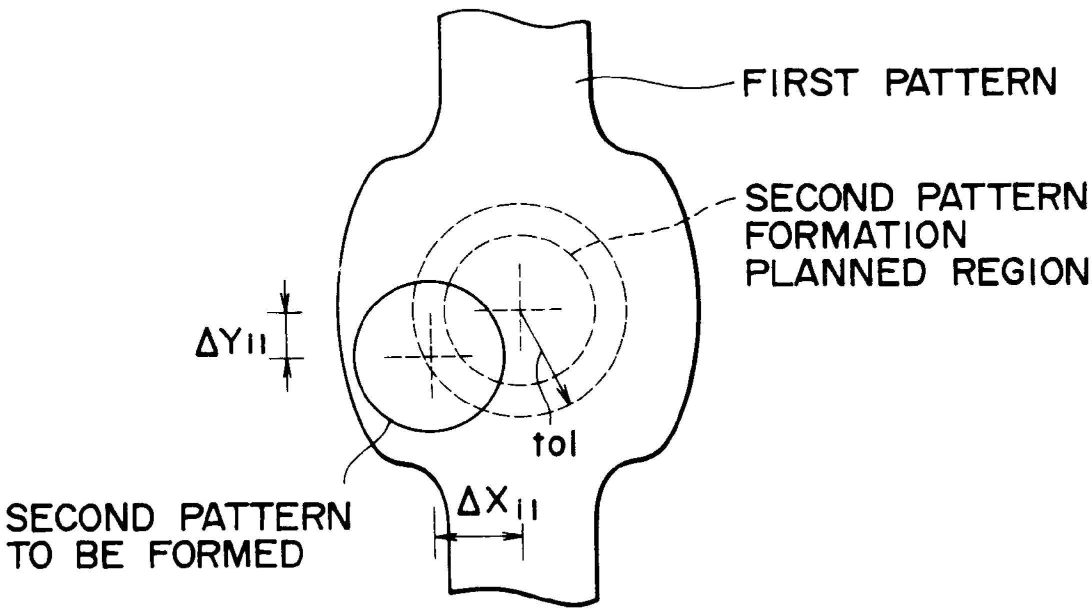

FIG. 19

IN THE CASE OF $\Delta e_X \geqq 0$

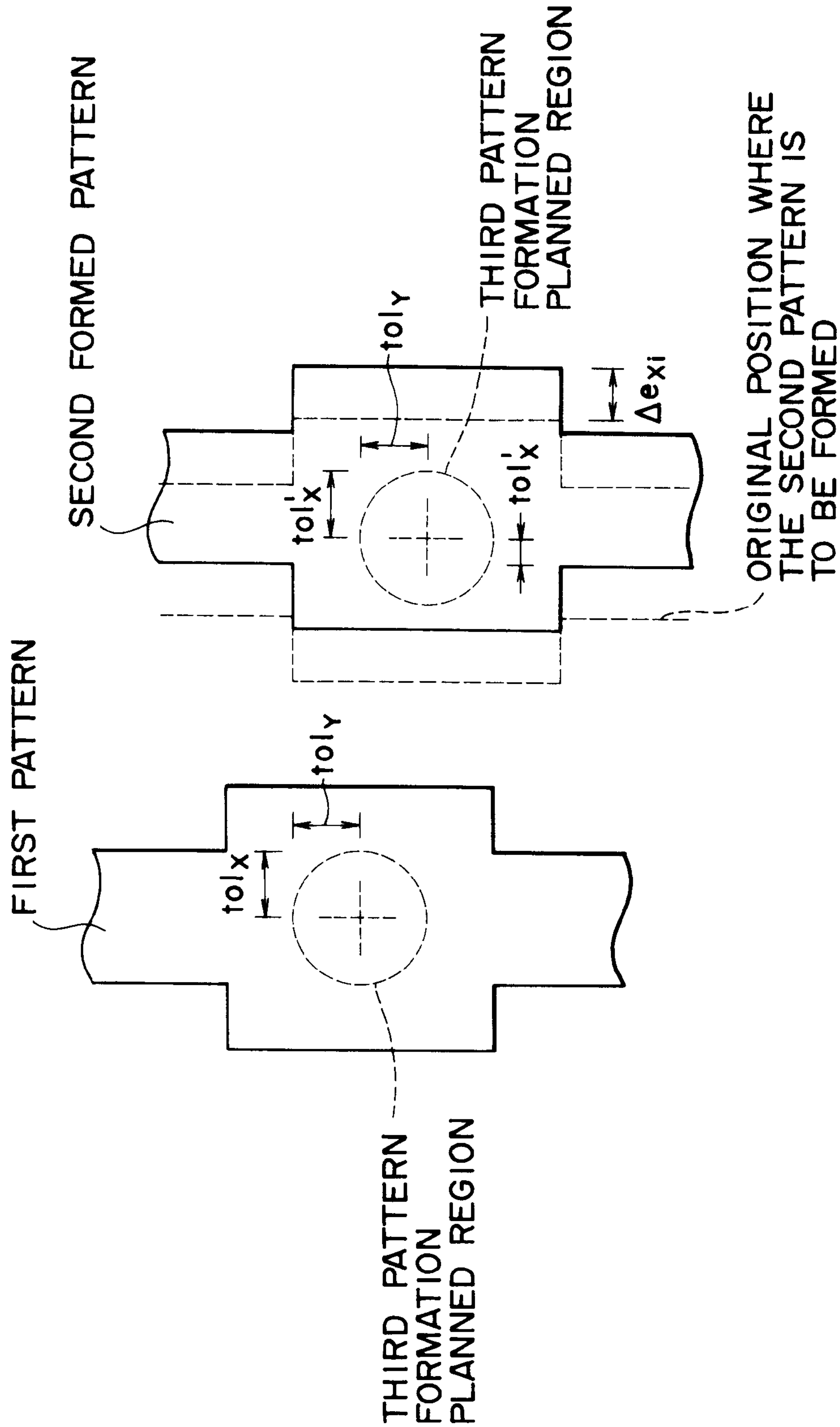

FIG. 20

IN THE CASE OF $\Delta e_X < 0$

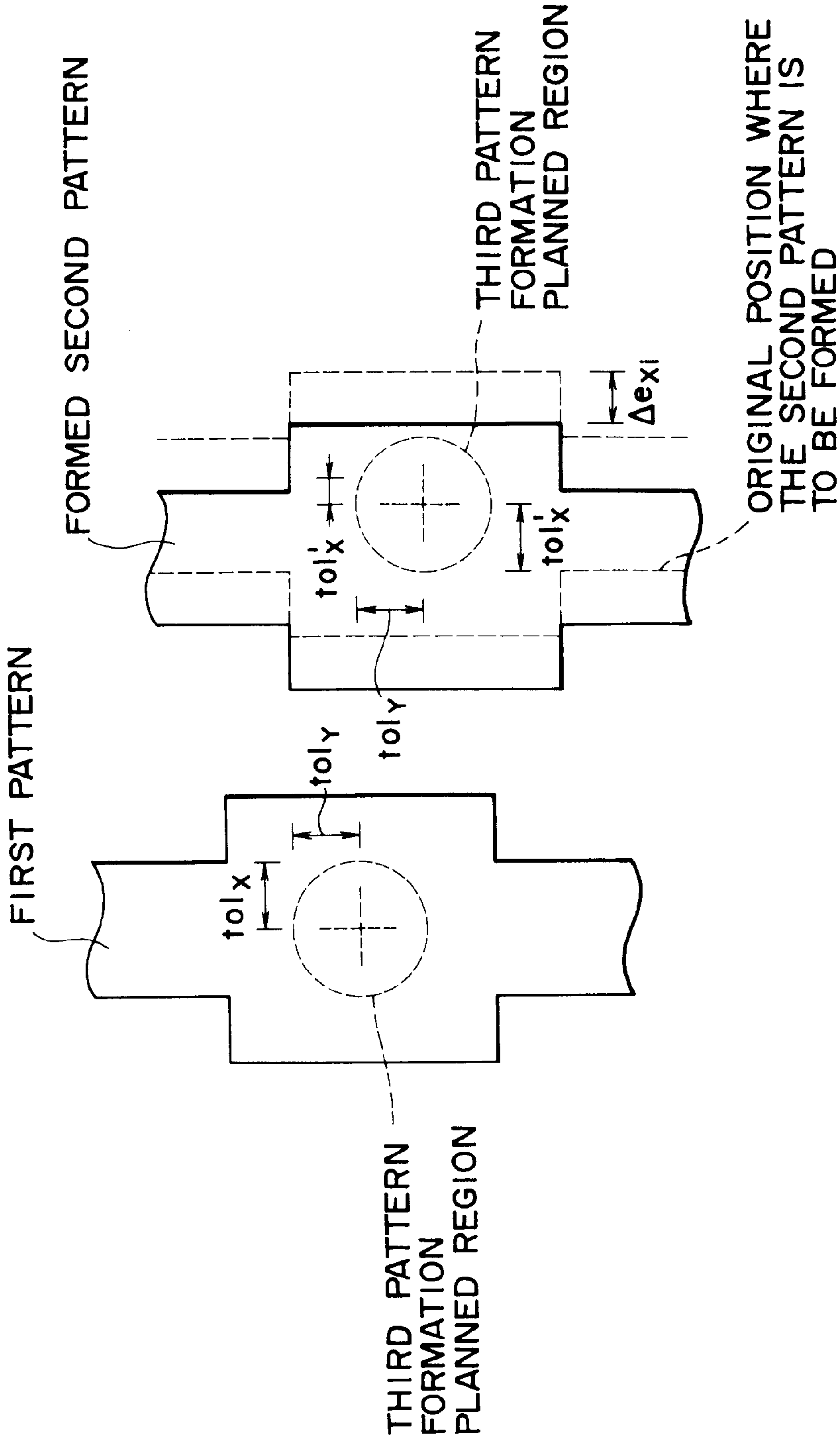

FIG. 21

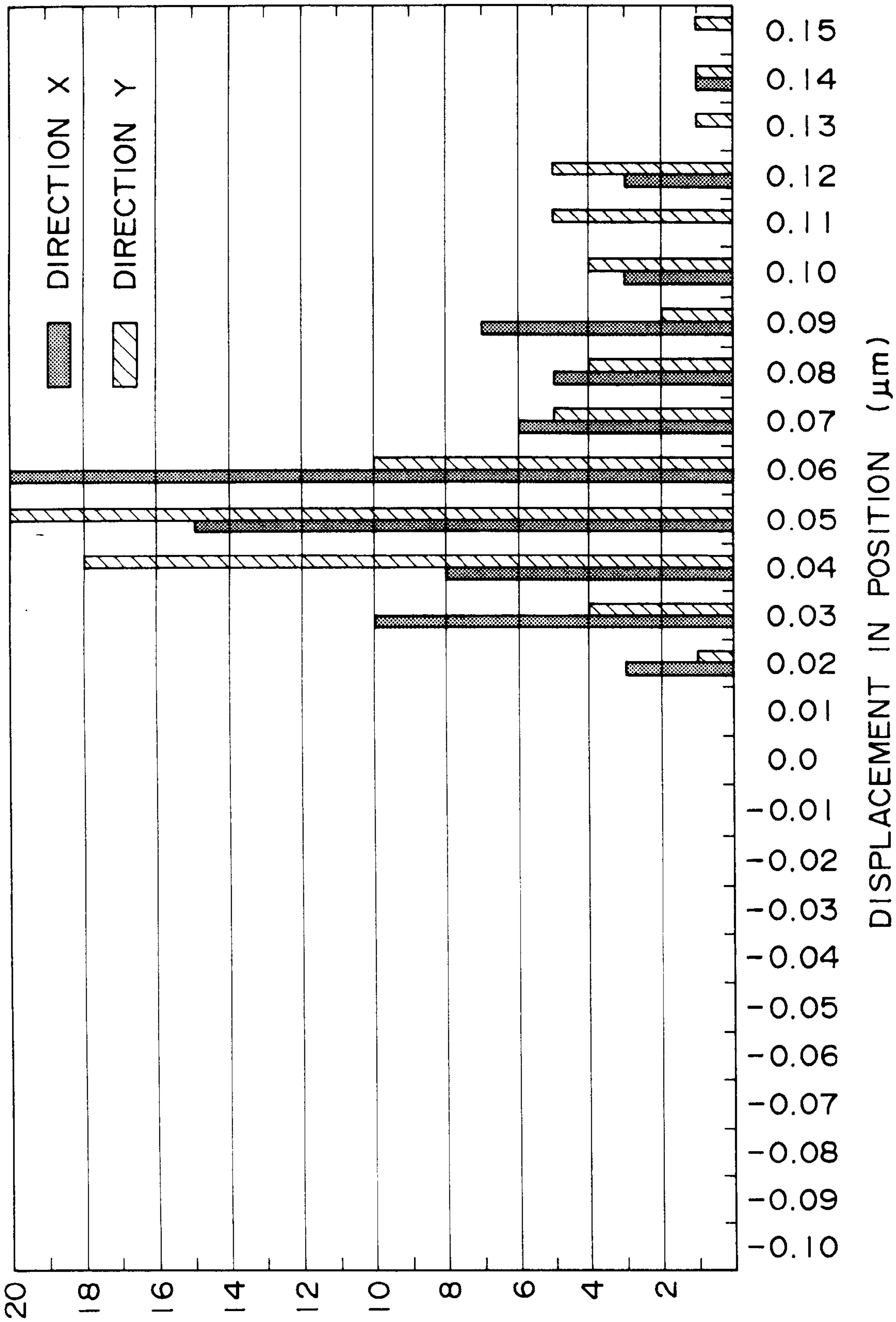

DIRECTION X
DIRECTION Y
DISPLACEMENT IN POSITION (μm)
0.15
0.14
0.13
0.12
0.11
0.10
0.09
0.08
0.07
0.06
0.05
0.04
0.03
0.02
0.01
0.0
-0.01
-0.02
-0.03
-0.04
-0.05
-0.06
-0.07
-0.08
-0.09
-0.10
20
18
16
14
12
10
8
6
4
2

FIG. 22

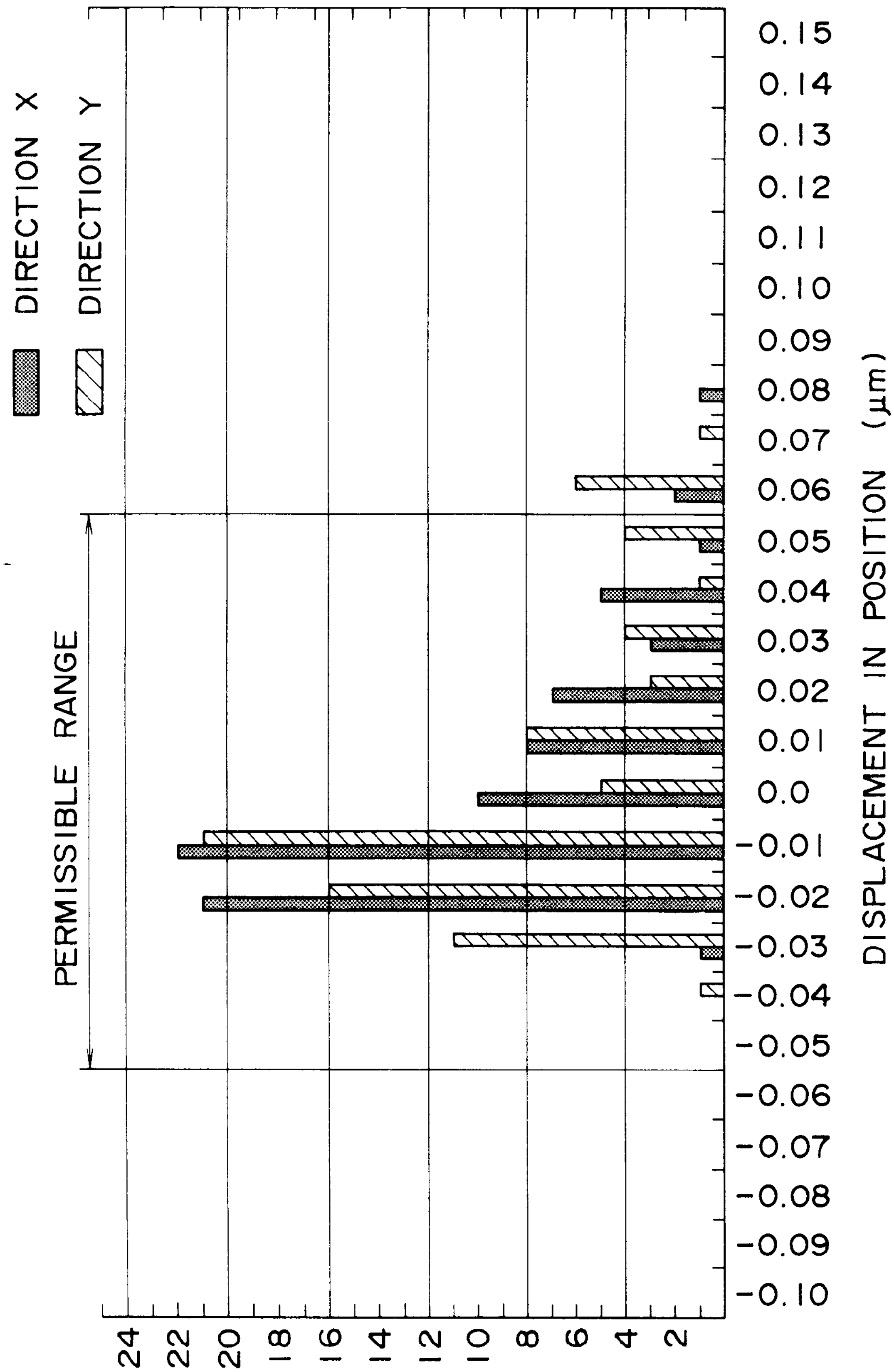

DIRECTION X
DIRECTION Y
PERMISSIBLE RANGE
DISPLACEMENT IN POSITION (μm)
0.15
0.14
0.13
0.12
0.11
0.10
0.09
0.08
0.07
0.06
0.05
0.04
0.03
0.02
0.01
0.0
−0.01
−0.02
−0.03
−0.04
−0.05
−0.06
−0.07
−0.08
−0.09
−0.10
24
22
20
18
16
14
12
10
8
6
4
2

FIG. 23

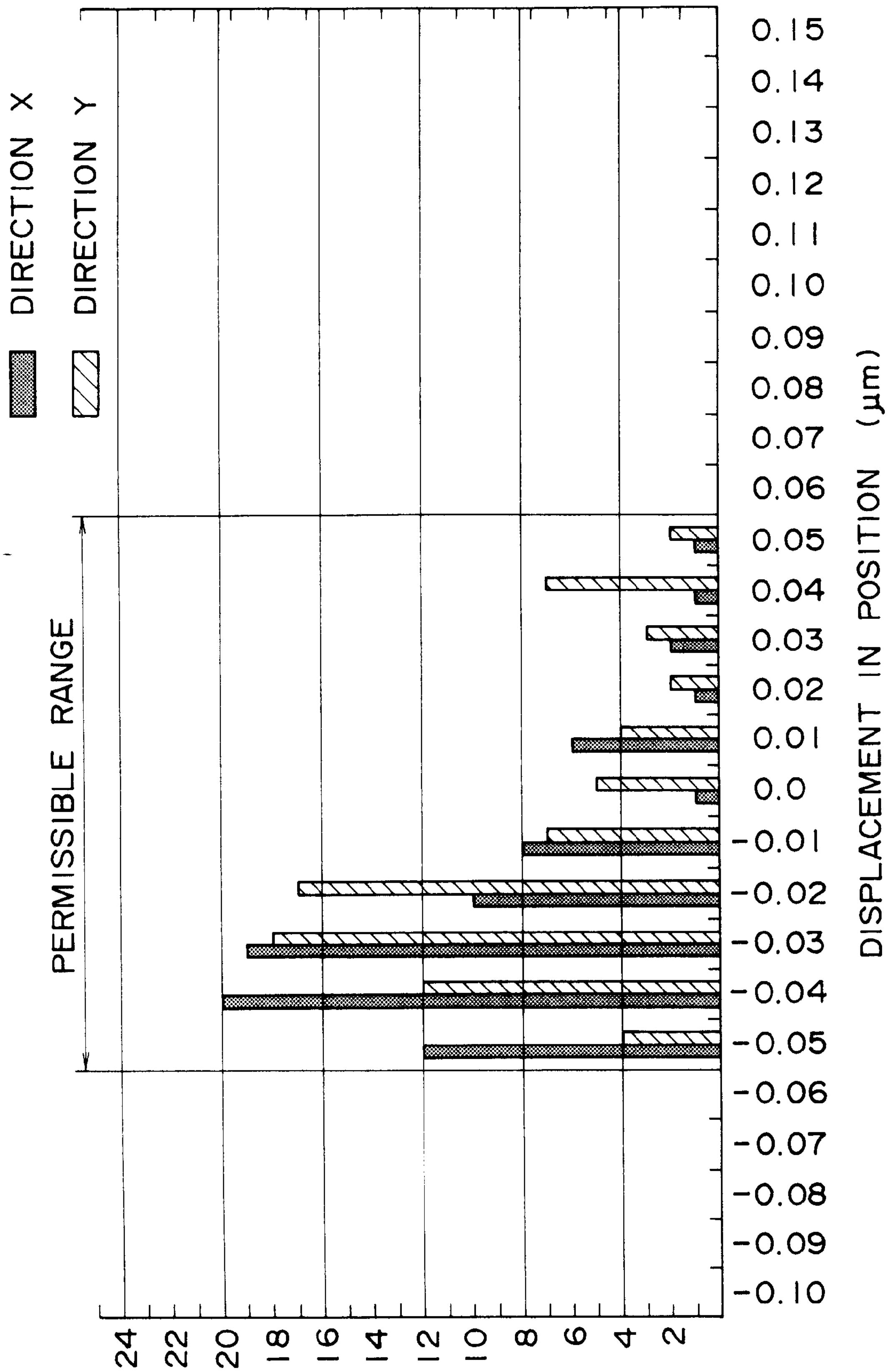

DIRECTION X
DIRECTION Y
PERMISSIBLE RANGE
0.15
0.14
0.13
0.12
0.11
0.10
0.09
0.08
0.07
0.06
0.05
0.04
0.03
0.02
0.01
0.0
-0.01
-0.02
-0.03
-0.04
-0.05
-0.06
-0.07
-0.08
-0.09
-0.10
DISPLACEMENT IN POSITION (μm)
24
22
20
18
16
14
12
10
8
6
4
2

FIG. 24

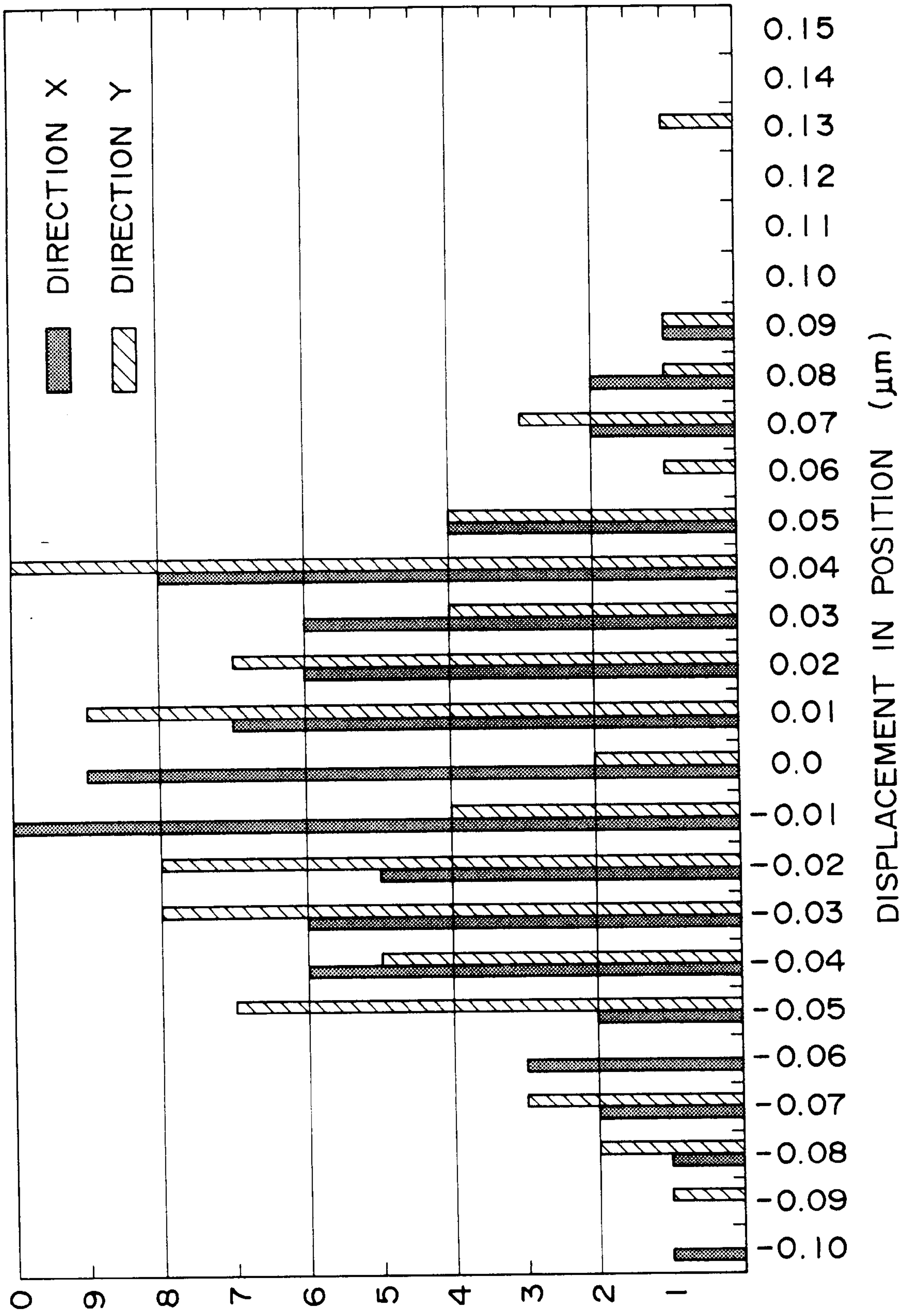
DIRECTION X
DIRECTION Y
DISPLACEMENT IN POSITION (μm)
0.15
0.14
0.13
0.12
0.11
0.10
0.09
0.08
0.07
0.06
0.05
0.04
0.03
0.02
0.01
0.0
-0.01
-0.02
-0.03
-0.04
-0.05
-0.06
-0.07
-0.08
-0.09
-0.10
10
9
8
7
6
5
4
3
2
1

FIG. 25

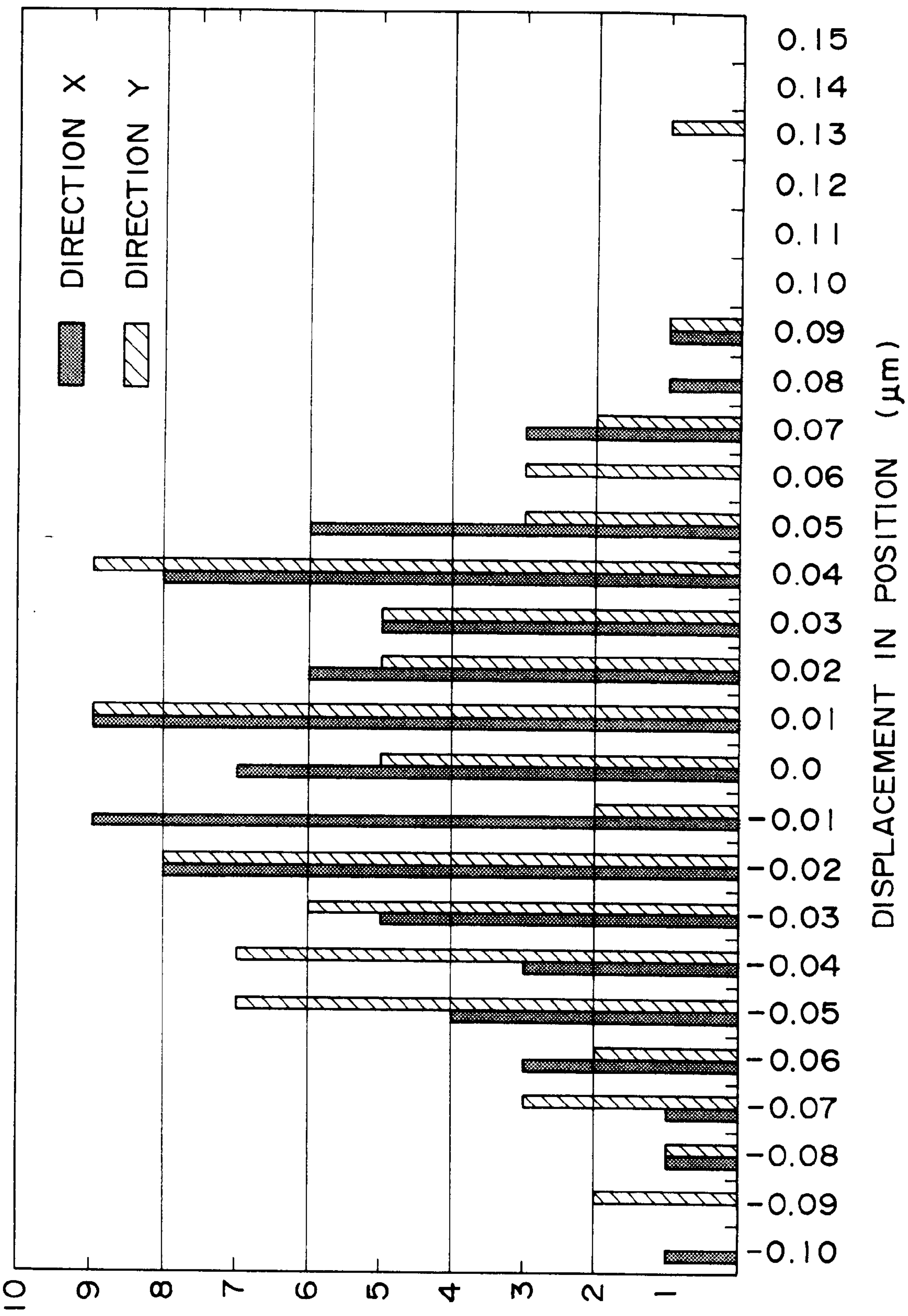
DIRECTION X
DIRECTION Y
DISPLACEMENT IN POSITION (μm)
0.15
0.14
0.13
0.12
0.11
0.10
0.09
0.08
0.07
0.06
0.05
0.04
0.03
0.02
0.01
0.0
−0.01
−0.02
−0.03
−0.04
−0.05
−0.06
−0.07
−0.08
−0.09
−0.10
10
9
8
7
6
5
4
3
2
1